# EUROPEAN PATENT APPLICATION

(11) **EP 3 187 983 A1**
(43) Date of publication of application: **05.07.2017**
(21) Application number: 15836258.2
(22) Date of filing: 14.08.2015
(51) Int. Cl.: G06F 3/041, G06F 3/044, G09G 3/20, G09G 3/30, H01L 51/50

(54) **ORGANIC ELECTROLUMINESCENT MODULE, SMART DEVICE, AND ILLUMINATION APPARATUS**

(30) Priority: 25.08.2014 JP 2014170019
(71) Applicant: Konica Minolta, Inc., Tokyo 100-7015 (JP)
(72) Inventor: OMATA, Kazuyoshi, Tokyo 100-7015 (JP); YAGI, Tsukasa, Tokyo 100-7015 (JP)
(74) Representative: Henkel, Breuer & Partner
(86) International application number: PCT/JP2015/072948
(87) International publication number: WO 2016/031593

(57) **Abstract**

This invention addresses the problem of providing the hollowing: an organic EL module that combines light-emission functionality with touch-detection functionality, contains a plurality of organic EL panels laid out in series and a specific control circuit, parevents erroneous touch detection between EL elements, makes a small format and low film thickness possible, and allows process simplification; and a smart device and an illumination apparatus provided with said organic EL module. This organic EL module is characterized by having touch-detection functionality and being provided with a touch-detection circuit unit and a light-emitting-element-driving circuit unit for an organic EL panel. This organic EL module is also characterized in that: said organic EL panel has a structure in which two or more organic EL elements are connected in series; and said organic EL elements have independent detecting means that can perform touch detection independently.

## Description

### TECHNICAL FIELD

The present invention relates an organic electroluminescent module having a touch-sensing function, a smart device and an illumination apparatus provided with the module.

### BACKGROUND

Examples of a conventional flat light source include a light emitting diode (hereafter, it is called as an LED) provided with a light guiding plate, and an organic light emitting diode (hereafter, it is called as an OLED).

Smart devices, such as smart phones and tablets, have acquired exponential increased sales on a world scale from around 2008. These smart devices are provided with a keyboard having a flat face in view of easy handling. For example, the keyboard corresponds to the icon region including common functional key buttons provided at the bottom of a smart device. One example combination of the common functional key buttons consists, for example, of "Home" (indicated by a square mark), "Return" (indicated by an arrow mark), and "Search" (indicated by a loupe mark).

In order to improve the visibility of these common functional key buttons, for example, LEDs are disposed together with a flat emission device, such as an LED light guiding plate, in tune with the pattern of the mark to be displayed in the interior of the smart device (refer to, for example, Patent document 1).

A capacitance-type information input unit with an LED light source is also disclosed. This input unit includes a flexible printed circuit (hereafter, it is called as FPC) having a highly sensitive sensor electrode that can certainly detect a variation in electrostatic capacitance and stabilize the input operation by a user, and an adhesive layer having a dielectric constant higher than that of an air layer having the same shape and disposed at positions other than the icon regions between the circuit and a surface panel (refer to, for example, Patent document 2).

Besides the LED light sources, use of surface emitting organic electroluminescent devices has come into action for display of icon regions for the purpose of a reduction of electric power consumption and more uniform light emission brilliance in recent years. To achieve display functions, these organic electroluminescent devices are provided on the rear sides of cover glasses, while icon marks have been preliminarily printed on the front sides of the cover glasses.

Smart devices inevitably require touch functions for use, and capacitive touch sensing devices for from display portions to common functional keys are usually disposed on the rear sides of the cover glasses.

A typical touch sensing device includes a film/film type touch sensor that is enlarged to the size of a cover glass and is laminated to the cover glass. For devices that can have any thickness, a touch sensor of a glass/glass type is also used in some cases. An electrostatic capacitance scheme has been applied to touch detection in many cases in recent years. "Projective capacitive touch sensors", which have fine electrode patterns along the x and y axes, have been used in main displays. In this scheme, two or more points can be touch-detected (so called "multi-touch").

Since such a touch sensor is used, a light-emitting device having no touch function has been used at a common functional key portion. Displays of an "in-cell" or "on-cell" type placed on the market, however, have highly demanded light-emitting devices having dedicated touch sensing functions for common functional keys.

Particularly, in a surface emission organic electroluminescent device, an anode, a cathode, or a metal foil protective layer, which is a composing member of an organic electroluminescent device, adversely affects the detection of the variation of the capacitance in the surface capacitive scheme. Therefore, in order to give an electrostatic touch function to an organic electroluminescent device, it is required to have an independent touch sensing electrode as an assembly for touch detection in addition to an organic electroluminescent panel. The assembly is composed of an electrostatic detecting circuit and an electrical connecting unit with a wiring section on a flexible board. For example, the assembly is a flexible printed circuit (FPC) on a light-emitting surface side. Such structure has a large restriction. In use of such assembly, a device for detecting the touch, such as an FPC, should be additionally prepared, resulting in several disadvantages, such as increased costs, increased thicknesses of the devices, and increased production steps.

An anode or a cathode is usually set as a touch sensing electrode (hereinafter simply referred to as "sensing electrode") in an organic EL panel or organic EL element, where Cf is a finger capacitance between the finger and the touch sensing electrode, and Cel is an interelectrode capacitance between the anode and the cathode. In this state, the capacitance between the anode and the cathode is "Cf + Cel" at a touch (finger-touch) and is Cel at no finger-touch. The interelectrode capacitance Cel is greater than the finger capacitance Cf in general organic EL panels or organic EL elements (Cf < Cel). Such relation precludes touch detection.

Further, it was tried to improve the efficiency of sensing functions by bonding in series an organic EL panel or organic EL element that constitutes a plurality of common functional key buttons. It was found out that there was produced a problem that other organic EL element received touch information when one organic EL element was touched with a finger to result in causing error sensing. This becomes a serious obstacle for making a configuration of a plurality of organic EL elements laid out in series.

Therefore, it is required a development of an organic electroluminescent module having a plurality of organic EL elements laid out in series as a light-emitting device for an icon section, and a wiring material for controlling the drive of the organic EL elements located effectively. This organic electroluminescent module enables to prevent error sensing, and achieving a small size and a small thickness, and it is suitable for a smart device.

### PIOR ART DOCUMENTS

### PATENT DOCUMENTS

Patent document 1: JP-A No. 2012-194291
Patent document 2: JP-A No. 2013-065429

### SUMMARY OF THE INVENTION

### PROBLEMS TO BE SOLVED BY THE INVENTION

The present invention has been made in view of the above-described problems and situations. An object of the present invention is to provide a specific organic electroluminescent module enabling to prevent error touch sensing in a touch function between a plurality of organic electroluminescent elements, with achieving a small format and a small thickness, and simplified process, and to provide a smart device and an illumination apparatus provided with this organic electroluminescent module. The specific organic electroluminescent module has an organic electroluminescent panel including a plurality of organic electroluminescent elements laid out in series provided with an electrode used for both a light-emission function and a touch-sensing function, and a specific control circuit.

### MEANS TO SOLVE THE PROBLEMS

The present inventors have made investigation to solve the above-described problems, and found out to solve the problems by a specific organic electroluminescent module to result in achieving the present invention.

This specific organic electroluminescent module is characterized in having: a touch sensing circuit unit containing a capacitive touch sensing circuit unit; and a light-emitting device driving circuit unit for driving an organic electroluminescent panel, wherein the electroluminescent panel has a configuration composed of two or more organic electroluminescent elements each laid out in series, and the organic electroluminescent elements laid out in series respectively have an independent sensing unit to carry out touch sensing independently.

In specific, the problems to be addressed by the present invention are solved by the following embodiments.

1. An organic electroluminescent module having a touch sensing function, the organic electroluminescent module comprising:
   a touch sensing circuit unit containing a capacitive touch sensing circuit section; and
   a light-emitting device driving circuit unit containing a light-emitting device driving circuit section for driving an organic electroluminescent panel,
   wherein the organic electroluminescent panel has a configuration composed of two or more organic electroluminescent elements each laid out in series,
   the organic electroluminescent element comprises paired opposite plate electrodes therein,
   one of the paired electrodes is a touch sensing electrode, the touch sensing electrode being connected to the touch sensing circuit unit, and
   the two or more organic electroluminescent elements laid out in series respectively have an independent sensing device to carry out touch sensing independently.
2. The organic electroluminescent module described in the embodiment 1, wherein the independent sensing device is a device having a switch at a connecting portion of the two or more organic electroluminescent elements laid out in series, and capable of independently sensing a finger-touch to each of the organic electroluminescent elements.
3. The organic electroluminescent module described in the embodiment 2, wherein the switch is turned on during an emission term of the organic electroluminescent element, and the switch is turned off during a touch sensing term.
4. The organic electroluminescent module described in the embodiments 2 or 3, wherein the switch is located in the light-emitting device driving circuit unit.
5. The organic electroluminescent module described in the embodiment 1, wherein the independent sensing device is a device having a resistor at a connecting portion of the two or more organic electroluminescent elements laid out in series, and capable of independently sensing a finger-touch to each of the organic electroluminescent elements by a time constant derived from the resistor and the organic electroluminescent element capacitance.
6. The organic electroluminescent module described in any one of the embodiments 1 to 5, wherein the touch sensing circuit unit and the light-emitting device driving circuit unit are connected to a common ground.
7. The organic electroluminescent module described in any one of the embodiments 1 to 5, wherein the touch sensing circuit unit and the light-emitting device driving circuit unit each are connected to an independent ground.
8. The organic electroluminescent module described in any one of the embodiments 1 to 7,
   wherein the emission term of the organic electroluminescent element controlled by the light-emitting device driving circuit section is separated from the touch sensing term controlled by the touch sensing circuit section, and
   at least one of the paired electrodes is in a floating potential during the touch sensing term to prevent detection of the capacitance of the respective organic electroluminescent element.
9. The organic electroluminescent module described in any one of the embodiments 1 to 7,
   wherein the emission term of the organic electroluminescent element controlled by the light-emitting device driving circuit section is separated from the touch sensing term controlled by the touch sensing circuit section, and
   both of the paired electrodes are in a floating potential during the touch sensing term to prevent detection of the capacitance of the respective organic electroluminescent panel.
10. The organic electroluminescent module described in any one of the embodiments 1 to 7,
   wherein the emission term of the organic electroluminescent panel controlled by the light-emitting device driving circuit section is separated from the touch sensing term controlled by the touch sensing circuit section, and
   at least one of the paired electrodes is in a floating potential and the paired electrodes are short-circuited during the touch sensing term to prevent detection of the capacitance of the respective organic electroluminescent panel.
11. The organic electroluminescent module described in any one of the embodiments 1 to 7,
   wherein the emission term of the organic electroluminescent panel controlled by the light-emitting device driving circuit section is separated from the touch sensing term controlled by the touch sensing circuit section, and
   both of the paired electrodes are in a floating potential and the paired electrodes are short-circuited during the touch sensing term to prevent detection of the capacitance of the respective organic electroluminescent panel.

12. The organic electroluminescent module described in any one of the embodiments 1 to 11,
wherein the organic electroluminescent element controlled by the light-emitting device driving circuit section is driven to continuously emit light, while the touch sensing term periodically occurs under the control of the touch sensing circuit section.

13. The organic electroluminescent module described in any one of the embodiments 1 to 11, wherein the emission term includes a reverse-voltage applying term at the end of the emission term.

14. A smart device comprising the organic electroluminescent module described in any one of the embodiments 1 to 13.

15. An illumination apparatus comprising the organic electroluminescent module described in any one of the embodiments 1 to 13.

### EFFECTS OF THE INVENTION

The above-described embodiments of the present invention can provide a specific organic electroluminescent module enabling to prevent error touch sensing in touch function between a plurality of organic electroluminescent elements, with achieving a small format and a small thickness, and simplified process, and to provide a smart device and an illumination apparatus provided with this organic electroluminescent module. The specific organic electroluminescent module has an organic electroluminescent panel including a plurality of organic electroluminescent elements laid out in series provided with an electrode used for both a light-emission function and a touch-sensing function, and a specific control circuit.

The technical features and mechanism to provide advantageous effects of the organic electroluminescent module defined in the present invention will now be described.

A conventional organic electroluminescent module applied to an icon region of a smart medium includes an organic electroluminescent panel including paired opposite electrodes and a touch sensing electrode for detecting a touch, such as a flexible printed circuit (FPC). In such a conventional organic electroluminescent module, a light-emitting function and a touch sensing function are provided by different assemblies. The conventional organic electroluminescent module having such a configuration inevitably has a large thickness, which hinders a reduction in sizes of an organic electroluminescent element.

To address the problem, the present inventors have proposed the following organic electroluminescent module (hereinafter simply referred to as "organic EL module"). The proposed module contains an organic electroluminescent panel (hereinafter simply referred to as "organic EL panel") contains an organic electroluminescent element (hereinafter simply referred to as "organic EL element") including a first electric controller and a second electric controller. The first electric controller is a light-emitting device driving circuit unit that is disposed between the paired opposite electrodes and is configured to control light emission. The second electric controller is a touch sensing circuit unit to cause at least one of the paired electrodes to function as a touch sensing electrode.

As describe above, an anode or a cathode is usually set as a touch sensing electrode (hereinafter simply referred to as "sensing electrode") in an organic EL panel or organic EL element, where Cf is a finger capacitance between the finger and the touch sensing electrode, and Cel is an interelectrode capacitance between the anode and the cathode. In this state, the capacitance between the anode and the cathode is "Cf + Cel" at a touch (finger-touch) and is Cel at no finger-touch. The interelectrode capacitance Cel is greater than the finger capacitance Cf in general organic EL panels or organic EL element (Cf < Cel). Such relation precludes touch detection.

In the above-described proposed organic EL module, the light-emitting device driving circuit unit and the touch sensing circuit unit are separately provided. In addition, at a touch detection, the switches between the anode and the cathode and the light-emitting deice driving circuit section are turned off and at least one of the anode and the cathode, or both of them are in a floating potential so that the interelectrode capacitance Cel between the anode and the cathode is not detected. This configuration can provide a touch sensing function and can contribute to reductions in sizes and thickness and simplified production steps of the organic electroluminescent device.

The present inventors have further investigated an efficient structure by connecting in series a plurality of organic EL elements constituting an organic EL module of a smart device as one of the means of improving the above-described structure.

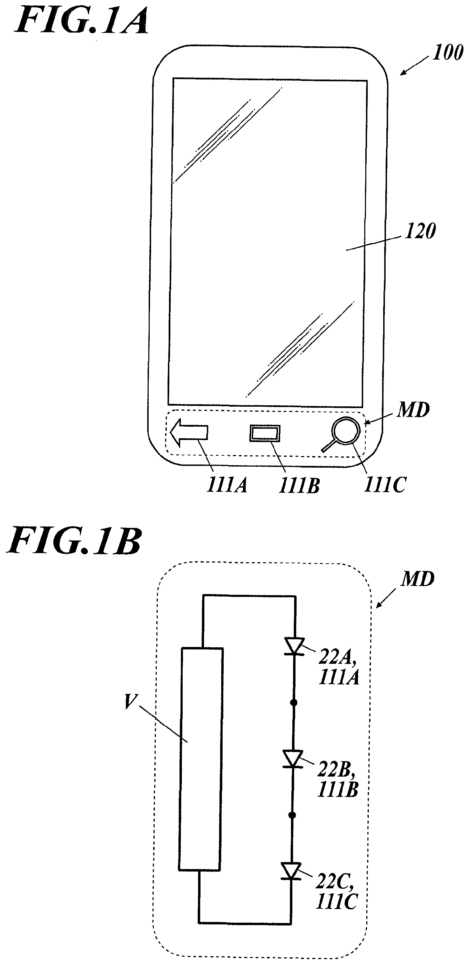

Fig. 1A is an outline view illustrating a representative smart device of the present invention. Fig. 1B is an outline view illustrating an example of a structure of an organic EL module provided at the icon section of the smart device.

In Fig. 1A, the smart device 100 is composed of an organic EL module (MD) having a touch sensing function, and a liquid crystal display 120. The liquid crystal display 120 may be of a known type.

Fig. 1A illustrates an illuminated state of the organic EL module (MD) of the present invention. Several displayed patterns (111A to 111C) are visible from an anterior view. In the non-illuminated state of the organic EL module (MD), these patterns (111A to 111C) are invisible. The displayed patterns (111A to 111C) in Fig. 1A are mere examples, and any other drawing, character, and design are also usable as patterns. The "displayed pattern" refers to a design, character, or image that is displayed by light emitted from the organic EL element. In the previous organic EL module (MD), the organic EL elements being an emission device are each respectively located. From the viewpoint of small format and small thickness of the device, it has been examined the method of carrying out emission and touch sensing by one applied electric source section V with a plurality of organic EL elements (22A to 22C) laid out in series as illustrated in Fig. 1B.

It was found out that error sensing will be produced when the organic EL elements are connected in series as illustrated in Fig. 1B.

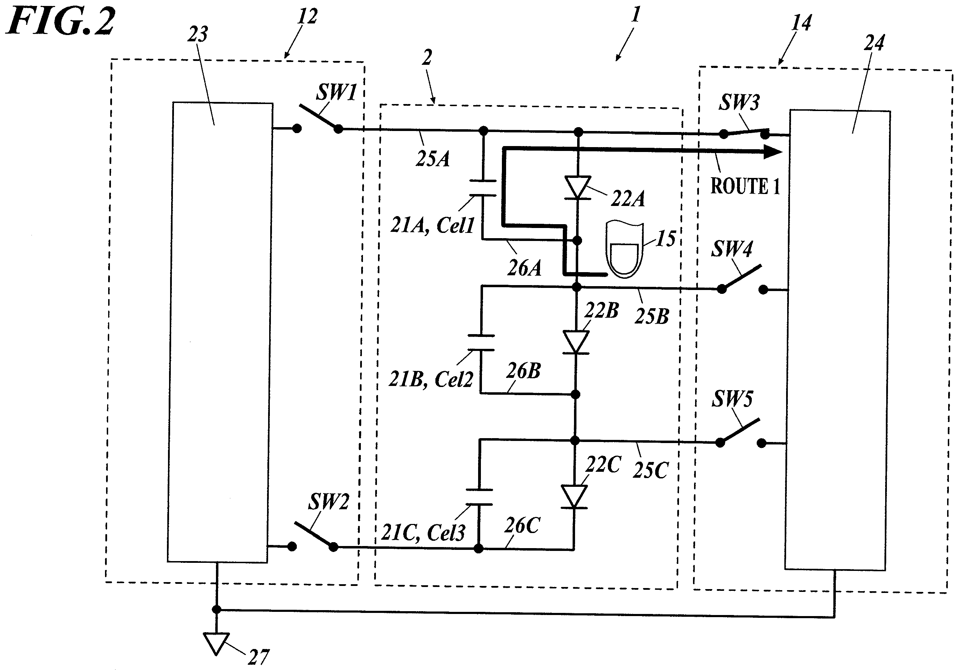

A detailed reason of this will be described by using Fig. 2. It was found out the following. When a plurality of organic EL elements are connected in series with a simple wiring, and when touch sensing is done by making a finger-touch to a first organic EL element, there may occur error detection of touch to the first organic EL element by a finger-touch to a second organic EL element that is primarily not an object of the touch sensing element.

After detailed investigation of the problems, the present inventors found out the following method for achieving the above-described object of the present invention. When an organic EL panel is composed of a plurality of organic EL elements connected in series, the following methods are efficient for preventing error sensing: a configuration of completely insulating the organic EL elements by placing a switch between the organic EL elements used for touch sensing; and a configuration of placing a resistor between the organic EL elements for utilizing a time constant.

### BRIEF DESCRIPTION OF THE DRAWINGS

Fig. 1A is an outline view illustrating a representative smart device of the present invention and an example of a structure of an organic EL module provided at the icon section of the smart device.
Fig. 1B is a schematic circuit diagram illustrating an example of a circuit configuration of a known organic EL module having three organic EL elements connected in series.
Fig. 2 is a circuit diagram illustrating an example of a configuration of an organic EL module having three conventional organic EL elements connected in series
Fig. 3 is a schematic cross-sectional view of an exemplary organic EL module of the present invention that includes an anode serving as a sensing electrode.
Fig. 4 is a driving circuit diagram in Embodiment 1 having a configuration provided with a switch between three organic EL elements in an organic EL module.
Fig. 5 is a schematic circuit diagram illustrating an example of a configuration of a light-emitting device driving circuit section.
Fig. 6 is a schematic circuit diagram illustrating an example of an emission control route at the emission driving during an emission term in Embodiment 1.
Fig. 7 is a schematic circuit diagram illustrating an example of a touch sensing information route by a finger-touch to a first organic EL element during a sensing term in Embodiment 1.
Fig. 8 is a schematic circuit diagram illustrating an example of a touch sensing information route by a finger-touch to a second organic EL element during a sensing term in Embodiment 1.
Fig. 9 is a schematic circuit diagram illustrating an example of a touch sensing information route by a finger-touch to a third organic EL element during a sensing term in Embodiment 1.
Fig. 10 is a timing chart illustrating an exemplary emission term and an exemplary sensing term in Embodiment 1.
Fig. 11 is a timing chart illustrating another exemplary emission term and sensing term (in the case of reverse voltage application) in Embodiment 1.
Fig. 12 is a driving circuit diagram in Embodiment 2 (having an independent sensing circuit) having a configuration of placing a switch between three organic EL elements in an organic EL module.
Fig. 13 is a timing chart illustrating an exemplary emission term and an exemplary sensing term in Embodiment 2.
Fig. 14 is a driving circuit diagram illustrating another exemplary organic EL module in Embodiment 3.
Fig. 15 is a schematic circuit diagram illustrating an example of a touch sensing information route by a finger-touch to a first organic EL element during a sensing term in Embodiment 3.
Fig. 16A is a schematic diagram illustrating a differential capacitance between in the emission term of the lighting moment of an organic EL element and in the sensing term (during finger-touch) in Embodiment 3.
Fig. 16B is a schematic diagram illustrating a differential capacitance between in the emission term of the touch sensing moment and in the sensing term (during finger-touch) in Embodiment 3.
Fig. 17 is a driving circuit diagram in Embodiment 4 having a configuration of placing a switch between three organic EL elements in an organic EL module and having two grounds.
Fig. 18 is a driving circuit diagram in Embodiment 5 having a configuration provided with a resistor between three organic EL elements composing an organic EL module.
Fig. 19 is a schematic circuit diagram illustrating an example of a touch sensing information route (normal sensing route) by a finger-touch to a first organic EL element in Embodiment 5.
Fig. 20 is a schematic circuit diagram illustrating an example of a touch sensing information route (error sensing route) during sensing of a first organic EL element in Embodiment 5 caused by a finger touch (error finger-touch) to a second organic EL element.
Fig. 21A is a schematic diagram illustrating a differential capacitance of a normal sensing route (route 5) in Embodiment 5.
Fig. 21B is a schematic diagram illustrating a differential capacitance of an error sensing route (route 6) in Embodiment 5.
Fig. 22 is a timing chart illustrating a time constant in Embodiment 5.
Fig. 23 is a timing chart illustrating an exemplary emission term and an exemplary sensing term in Embodiment 5.
Fig. 24 is a driving circuit diagram of another exemplary organic EL module (continuous emission of organic EL element) in Embodiment 6.
Fig. 25 is a timing chart illustrating an exemplary emission term and an exemplary sensing term in Embodiment 6.
Fig. 26 is a driving circuit diagram of another exemplary organic EL module (continuous emission of organic EL element) in Embodiment 7.
Fig. 27 is a schematic cross-sectional view illustrating another exemplary organic EL module of the present invention having another configuration (a cathode electrode has a function of a touch sensing electrode).
Fig. 28 is a driving circuit diagram of an organic EL module of Embodiment 8 that includes a cathode electrode having a function of a touch sensing electrode.

### EMBODIMENTS TO CARRY OUT THE INVENTION

An organic EL module of the present invention has a touch sensing function, and it includes a touch sensing circuit unit containing a capacitive touch sensing circuit section and a light-emitting device driving circuit unit containing a light-emitting device driving circuit section for driving an organic EL panel. The organic EL panel has a configuration composed of two or more organic EL elements each laid out in series, the organic El element comprises paired opposite plate electrodes therein, one of the paired electrodes is a touch sensing electrode, the touch sensing electrode being connected to the touch sensing circuit unit, and the two or more organic EL elements laid out in series respectively have an independent sensing device to carry out touch sensing independently. These technical features are common to the inventions described in the embodiments 1 to 15.

A preferable embodiment of the present invention is as follows from the viewpoint of obtaining the required effect of the present invention. The independent sensing device is a device having a switch at a connecting portion of the two or more organic electroluminescent elements laid out in series, and capable of independently sensing a finger-touch to each of the organic electroluminescent elements. This embodiment can surely prevent error sensing at the finger-touch to the organic EL elements.

In a preferred embodiment of the present invention, the switch is made in the "ON" state during an emission term of the organic electroluminescent element, and the switch is made in the "OFF" state during a touch sensing term from the viewpoint of surely preventing error sensing at the finger-touch to the organic EL elements.

In a preferred embodiment of the present invention, the switch is located in the light-emitting device driving circuit unit from the viewpoint of effectively preventing error sensing at the finger-touch to the organic EL elements.

In a preferred embodiment of the present invention, the independent sensing device is a device having a resistor at a connecting portion of the two or more organic electroluminescent elements laid out in series, and capable of independently sensing a finger-touch to each of the organic electroluminescent elements by a time constant derived from the resistor and the organic electroluminescent element capacitance. This is preferable from the viewpoint of surely preventing error sensing at the finger-touch to the organic EL elements.

In a preferred embodiment of the present invention, the touch sensing circuit unit and the light-emitting device driving circuit unit are connected to a common ground from the viewpoint of enabling to design a more simplified and more effective controlling circuit.

In a preferred embodiment of the present invention, the touch sensing circuit unit and the light-emitting device driving circuit unit each are connected to an independent ground. The touch sensing electrode is substantially not affected by the capacitance of the organic EL element when viewed from the touch sensing circuit unit. Only the capacitance formed with the finger and the sensing electrode is detected. This enables to improve the touch sensing sensitivity.

In a preferred embodiment of the present invention, the emission term of the organic electroluminescent panel controlled by the light-emitting device driving circuit unit is separated from the touch sensing term of the organic electroluminescent panel controlled by the touch sensing circuit unit and at least one of the paired electrodes is in a floating potential during the touch sensing term to prevent detection of the capacitance of the organic electroluminescent panel. This configuration can definitely separate the emission term from the sensing term.

In a preferred embodiment of the present invention, the emission term of the organic electroluminescent panel controlled by the light-emitting device driving circuit unit is separated from the touch sensing term of the organic electroluminescent panel controlled by the touch sensing circuit unit and both of the paired electrodes are in a floating potential during the touch sensing term to prevent detection of the capacitance of the organic electroluminescent panel. This configuration can definitely separate the emission term from the sensing term.

In a preferred embodiment of the present invention, the emission term of the organic electroluminescent panel controlled by the light-emitting device driving circuit unit is separated from the touch sensing term of the organic electroluminescent panel controlled by the touch sensing circuit unit, at least one of the paired electrodes is in a floating potential during the touch sensing term and the paired electrodes are short-circuited to prevent detection of the capacitance of the organic electroluminescent panel. This configuration can definitely separate the emission term from the sensing term.

In a preferred embodiment of the present invention, the emission term of the organic electroluminescent panel controlled by the light-emitting device driving circuit unit is separated from the touch sensing term of the organic electroluminescent panel controlled by the touch sensing circuit unit, at least one of the paired electrodes is in a floating potential during the touch sensing term and the paired electrodes are short-circuited to prevent detection of the capacitance of the organic electroluminescent panel. This configuration can definitely separate the emission term from the sensing term.

In the present invention, a floating potential state is a state of not connected to a ground of a power source of an apparatus. Since the anode or the cathode is in the floating potential at touch detection, a finger-touch can be detected without detection of the interelectrode capacitance Cel of the organic EL panel.

In a preferred embodiment of the present invention, the organic EL element controlled by the light-emitting device driving circuit section is driven to continuously emit light, while the touch sensing term under the control of the touch sensing circuit section intermittently occurs, in view of achievement in a simplified circuit and effective sensing functions.

In a preferred embodiment of the present invention, the emission term includes a reverse-voltage applying term at the end of the emission term. This configuration can definitely separate the emission term from the sensing term.

In the present invention, an organic EL element includes paired opposite electrodes and an organic functional layer group. The organic EL panel of the present invention includes the organic EL element sealed with a sealing resin and sealing member. The organic EL module of the present invention includes the organic EL panel connected to the capacitive touch sensing circuit unit and the light-emitting device driving circuit unit via an electric connector to provide a light-emitting function and a touch sensing function.

Components of the present invention and embodiments or aspects of the present invention will now be described in detail with reference to the attached drawings. As used herein, the expression "to" indicating a numerical range is meant to be inclusive of the boundary values. In the description of the drawings, the numbers in parentheses correspond to the reference numerals in the drawings.

### <<Organic EL module>>

An organic EL module of the present invention includes an organic EL panel having a plurality of organic EL elements joined with an electric connector. The electric connector includes a capacitive touch sensing circuit unit containing a capacitive touch sensing circuit section, and a light-emitting device driving circuit unit including a light-emitting device driving circuit section for driving the organic EL panel. The organic EL panel is provided with two or more organic EL elements, and the organic EL element includes paired opposite plate electrodes therein. The paired electrodes are connected to the light-emitting device driving circuit unit. One of the paired electrodes functions as a touch sensing electrode, and the touch sensing electrode is connected to the touch sensing circuit unit.

Before the detailed description on the configuration of the organic EL module of the present invention, it will be described a schematic configuration of a conventional organic EL module containing an organic EL panel provided with two or more organic EL elements.

Fig. 2 is a circuit diagram illustrating an example of a configuration of an organic EL module having three conventional organic EL elements connected in series

In Fig. 2 illustrating a circuit diagram for driving the organic EL module (1), the organic EL panel (2), which is illustrated on the middle of the drawing, includes an anode lead (25A to 25C) and a cathode lead (26A to 26C). Three organic EL elements (22A to 22C) (being a diode) and a parasitic capacitance (21A to 21C) of the organic EL elements are connected to the both leads. It has a configuration that a direct wiring is made between the cathode lead (26A) and the anode lead (25B), and between the cathode lead (26B) and the anode lead (25C).

In the light-emitting device driving circuit unit (12), which is illustrated on the left of the drawing, the anode lead (25A) extending from the anode of a first organic EL element (22A) is connected to a light-emitting device driving circuit section (23) via a first switch (SW1), and the cathode lead (26C) extending from the cathode (6C) (not shown) of a third organic EL element (22C) is connected to the light-emitting device driving circuit section (23) via a second switch (SW2). The light-emitting device driving circuit section (23) is also connected to a ground (27). The ground (27) is particularly referred to as a "signal-ground".

On the other hand, the touch sensing circuit unit (14), which is illustrated on the right of the drawing, has the following configuration. An anode lead (25A) that is taken out from an anode (4A) (not shown), which makes function as a touch sensing electrode in the first organic EL element (22A), is connected to a touch sensing circuit section (24) via a third switch (SW3). An anode lead (25B) that is taken out from a touch sensing electrode in the second organic EL element (22B) is connected to a touch sensing circuit section (24) via a fourth switch (SW4), and an anode lead (25C) that is taken out from a touch sensing electrode in the third organic EL element (22C) is connected to a touch sensing circuit section (24) via a fifth switch (SW5). The configuration of the light-emitting device driving circuit unit (12) and the configuration of the touch sensing circuit unit (14) will be described later in the portion describing the organic EL module (1) of the present invention.

In the conventional circuit configuration as described above, touch sensing is carried out as follows. After forming an emission term by making SW1 and SW2 to be in the "ON" state, a sensing term is made by making SW1, SW2, SW4, and SW5 to be in the "OFF" state as illustrated in Fig. 2, for example. In the sensing term by using the first organic EL element (22A), only SW3 is made to be in the "ON" state, and touch sensing is done by making a finger-touch to the anode electrode that is a touch sensing electrode.

However, when the touch sensing is carried out by using the first organic EL element (22A), it may be produced a problem of error sensing by the following case as illustrated in Fig. 2. When a finger-touch (15) is made to the anode electrode (4B) (not shown) that is a touch sensing electrode and connected to the anode lead (25B) of the second organic EL element (22B), information that the first organic EL element (22A) is touched is transferred to the touch sensing circuit section (24) via a route 1 as a touch sensing information route. An object of the present invention is to prevent error sensing in the organic EL module composed of a plurality of organic EL elements laid out in series.

In the following, the organic EL module having resolved the above-described problem of error sensing is described in detail by referring to figures.

An organic EL module of the present invention is characterized in that it has: a touch sensing circuit unit containing a capacitive touch sensing circuit section; and a light-emitting device driving circuit unit containing a light-emitting device driving circuit section for driving an organic EL panel, wherein the organic EL panel has a configuration composed of two or more organic EL elements each laid out in series, the two or more organic EL elements laid out in series respectively have an independent sensing device to carry out touch sensing independently.

One of more preferable embodiments is that the independent sensing device is a device having a switch at a connecting portion of the two or more organic EL elements laid out in series, and capable of independently sensing a finger-touch to each of the organic EL elements.

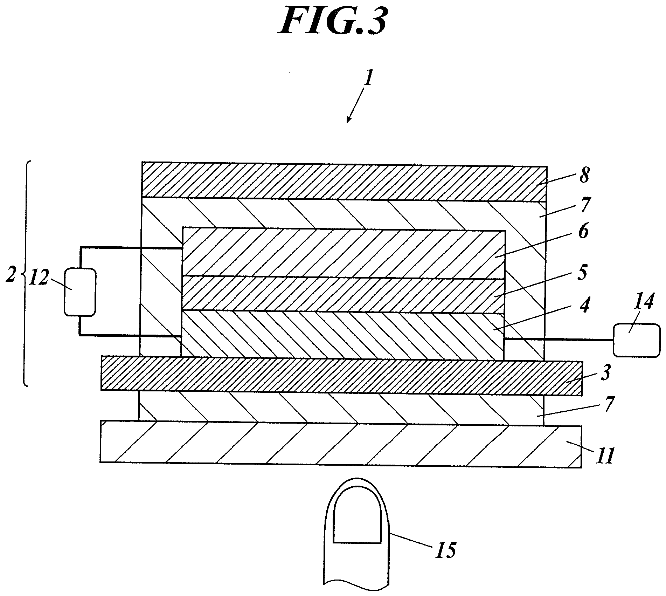

First, a schematic composition of the configuration of the organic EL module of the present invention that includes an anode serving as a sensing electrode will be described with reference to Fig. 3. In the organic EL module described below, it will be described a configuration in which an anode is used as a touch sensing electrode.

Fig. 3 illustrates an outline view of only one of the two or more organic EL elements composing an organic EL module of the present invention for the sake of convenience.

An organic EL panel (2) constituting an organic EL module (1) in Fig. 3 includes an emission region that is a laminate of, in sequence, a transparent substrate (3), an anode (4), and an organic functional layer unit (5). A cathode (6) is laminated on the organic functional layer unit (5) to give an organic EL element. The outer periphery of the organic EL element is sealed with a sealing adhesive (7). A sealing member (8) is disposed on the sealing adhesive (7) to form an organic EL panel (2).

The organic EL panel (2) according to the present invention may include an optional metal foil layer on the surface side of the organic EL panel (2) compared with an anode (4) or a cathode (6) for the protection of the organic EL element.

In the configuration illustrated in Fig. 3, the anode (4), which is a counter electrode to cause the organic EL element to emit light, functions as a touch sensing electrode. For example, in the configuration composed of three organic EL elements, the light-emitting device driving circuit unit (12) that controls emission is connected between the anode (4A) (not shown) of the first organic EL element and the cathode (6) of the third organic EL element. In the light-emitting device driving circuit unit (12), a ground (not shown) is provided. A cover glass (11) is placed on the rear side (display side) of the transparent substrate (3) through the sealing adhesive (7).

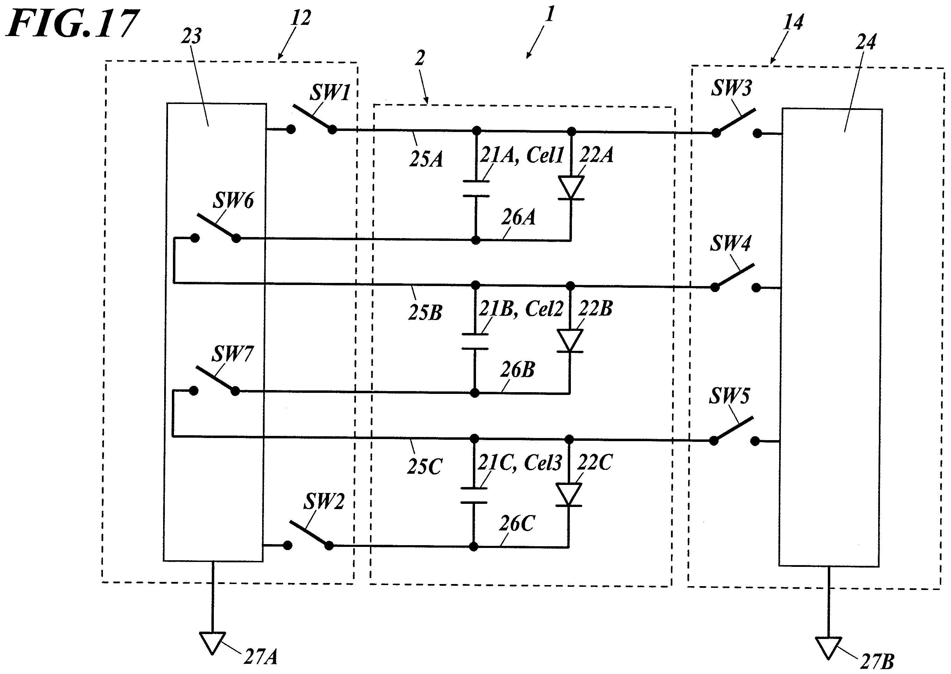

The anode of each organic EL element has a function as a sensing electrode, and it is connected to the touch sensing circuit unit (14) to detect the touch (15, hereafter, it is also called as a finger-touch). Here, the touch sensing circuit unit (14) may have a constitution of being provided with an independent ground (not sown). The constitution of having two grounds will be described later in the section of describing Fig. 17.

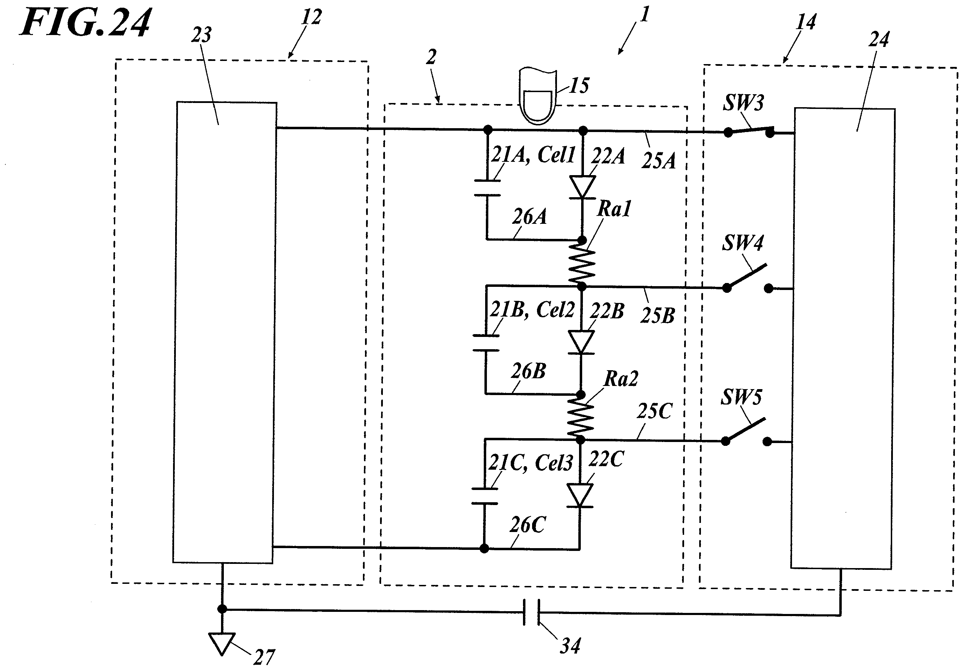

Fig. 3 illustrates the configuration in which the anode (4) serves as a sensing electrode. As described later for Fig. 24, it is possible to give the function of a sensing electrode to the cathode (6).

Next, a specific driving circuit constituting the organic EL module of the present invention and the method of driving the organic EL module will be described.

### [Exemplary configuration of organic EL module : the case in which a touch sensing electrode is an anode]

### (Embodiment 1)

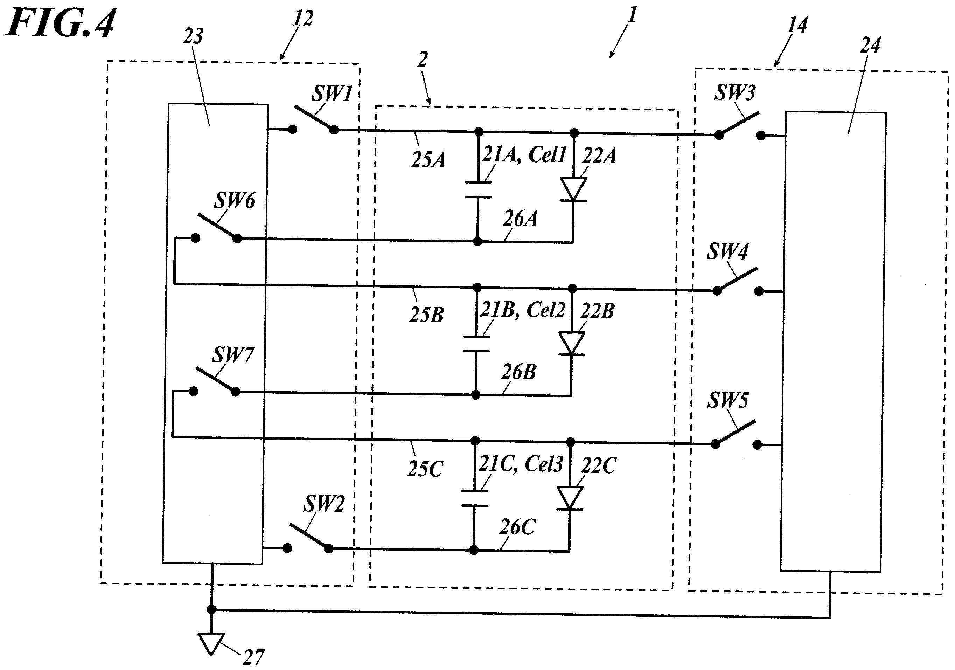

Fig. 4 illustrates an example of a driving circuit in the configuration (Embodiment 1) having switches between three organic El elements in an organic EL module of the present invention.

In Fig. 4 illustrating a circuit diagram for driving the organic EL module (1), in the same manner as in Fig. 2, the organic EL panel (2), which is illustrated on the middle of the drawing, includes an anode lead (25A to 25C) and a cathode lead (26A to 26C). Three organic EL elements (22A to 22C) (being a diode) and a parasitic capacitance (21A (Cel 1) to 21C (Cel 3)) of the organic EL elements are connected to the both leads.

In the light-emitting device driving circuit unit (12), which is illustrated on the left of the drawing, the anode lead (25A) extending from the anode (4A) (not shown) of a first organic EL element (22A) is connected to a light-emitting device driving circuit section (23) via a first switch (SW1). The cathode lead (26C) extending from the cathode (6C) (not shown) of a third organic EL element (22C) is connected to the light-emitting device driving circuit section (23) via a second switch (SW2).

The light-emitting device driving circuit unit (12) includes a constant-current driving circuit or a constant-voltage driving circuit to control the timing of the light emission of the organic EL element. The light-emitting device driving circuit unit (12) also includes the light-emitting device driving circuit section (23) that applies a reverse bias voltage (reverse applied voltage), as required. The light-emitting device driving circuit section (23) and the first switch (SW1) are independently provided in Fig. 4; alternatively, the first switch (SW1) may be incorporated in the light-emitting device driving circuit section (23), if needed.

On the other hand, the touch sensing circuit unit (14), which is illustrated on the right of the drawing, has the following configuration. An anode lead (25A) that is taken out from an anode (4A) (not shown), which makes function as a touch sensing electrode in the first organic EL element (22A), is connected to a touch sensing circuit section (24) via a third switch (SW3). An anode lead (25B) that is taken out from an anode (4B) (not shown) being a touch sensing electrode in the second organic EL element (22B) is connected to a touch sensing circuit section (24) via a fourth switch (SW4), and an anode lead (25C) that is taken out from an anode (4C) (not shown) being a touch sensing electrode in the third organic EL element (22C) is connected to a touch sensing circuit section (24) via a fifth switch (SW5).

The feature of the driving circuit of the organic EL module in Embodiment 1 of the present invention is as follows. In order to prevent error sensing, a sixth switch (SW6) is placed in the circuit between the cathode lead (26A) and the anode lead (25B) for interrupting an electric signal of the first organic EL element and the second organic EL element. In the same manner, a seventh switch (SW7) is placed in the circuit between the cathode lead (26B) and the anode lead (25C) for interrupting an electric signal of the second organic EL element and the third organic EL element.

The light-emitting device driving circuit unit (12) of the present invention has a configuration as illustrated by a dotted line in Fig. 4. It has a range of circuit composed of an anode lead (25A), SW1, a light-emitting device driving circuit section (23), a cathode lead (26C) and SW2. Further, SW6 and SW7, which is a feature of the present invention, are incorporated in the light-emitting device driving circuit section (23).

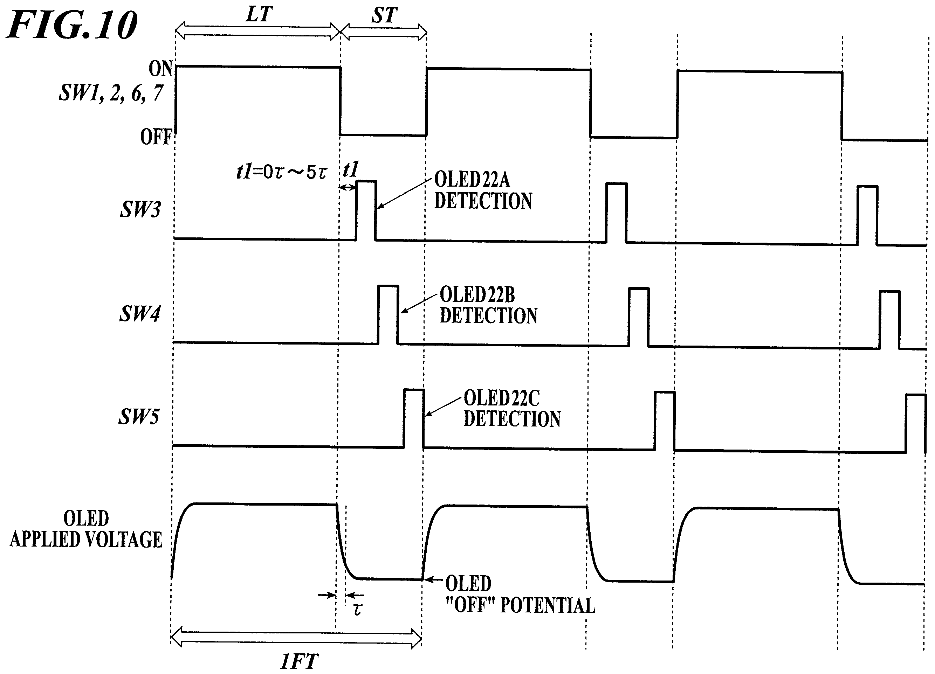

The light-emitting device driving circuit section (23) according to the present invention may have any configuration, and thus may be a known light-emitting device driving circuit section (organic EL element driving circuit). For example, a general light-emitting device driving circuit has a function to apply current flowing through the anode and the cathode in accordance with a required intensity of light to be emitted from the light-emitting device or the organic EL element in a predetermined emission pattern illustrated in Fig. 10 described below. A known example of such a light-emitting device driving circuit (23) is a constant-current circuit that includes a step-up or step-down DC-DC converter circuit, a current feedback circuit, and a switch controlling circuit for the DC-DC converter, for example. In addition, the light-emitting device driving circuits described in, for example, JP-A Nos. 2002-156944, 2005-265937, and 2010-040246 may be applicable.

The first to seventh switches (SW1 to SW7) may be of any type, for example, a field-effect transistor (FET) and a thin-film transistor (TFT).

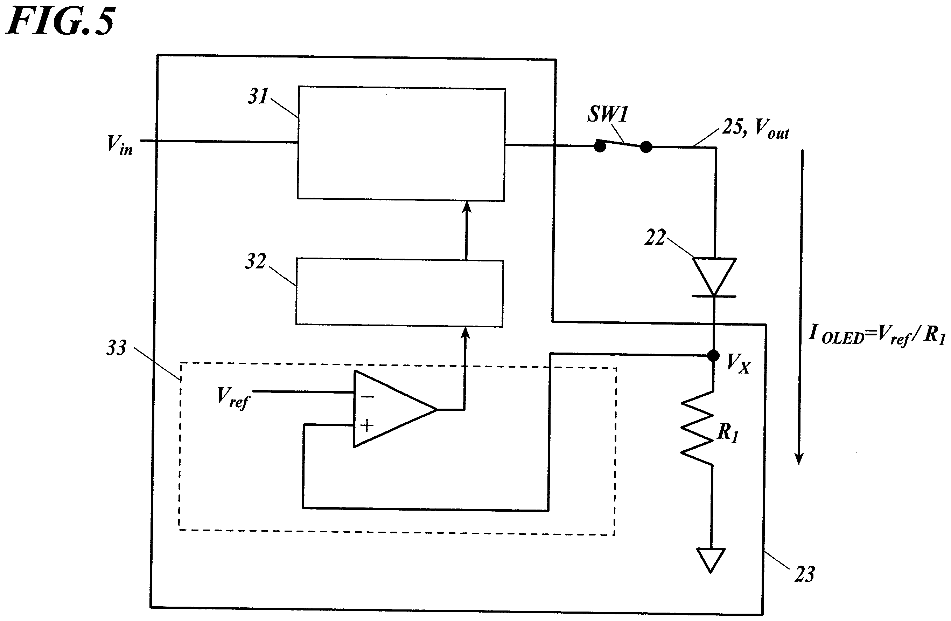

Fig. 5 illustrates an exemplary light-emitting device driving circuit section (23) applicable to the present invention.

Fig. 5 is a schematic circuit diagram of an exemplary light-emitting device driving circuit unit according to the present invention.

In Fig. 5, the light-emitting device driving circuit section (23) includes a set-up or set-down DC-DC converter circuit (31), a switching controlling circuit (32) for the DC-DC converter, and a current feedback circuit (33). For example, the anode potential of the organic EL element (22) is raised or dropped at the DC-DC converter circuit (31) so that the current I_{OLED} flowing into the organic EL element (22) becomes V_{ref}/R₁, where R₁ is sensing resistance and V_{ref} is comparative potential. Such a configuration allows the light-emitting device driving circuit section (23) to function as a constant-current circuit. An output Vₒᵤₜ from the DC-DC converter circuit (31) is fed back to the feedback circuit (33) such that V_{X} = V_{ref} is satisfied. For example, if V_{ref} is 0.19 V and R₁ is 100 Ω, the DC-DC converter circuit (31) controls Vₒᵤₜ such that the constant-current value V_{ref}/R₁ is 1.9 mA.

The touch sensing circuit section (24) may have any configuration, and it may be a known touch sensing circuit section. A general touch sensing circuit includes, for example, an amplifier, a filter, an AD converter, a rectification smoothing circuit, and a comparator. Representative examples of the touch sensing circuit include a self-capacitive sensing circuit and a series capacitive voltage divider circuit (of an Omron type). In addition, the touch sensing circuits described in, for example, JP-A Nos. 2012-073783, 2013-088932, and 2014-053000 may be applicable.

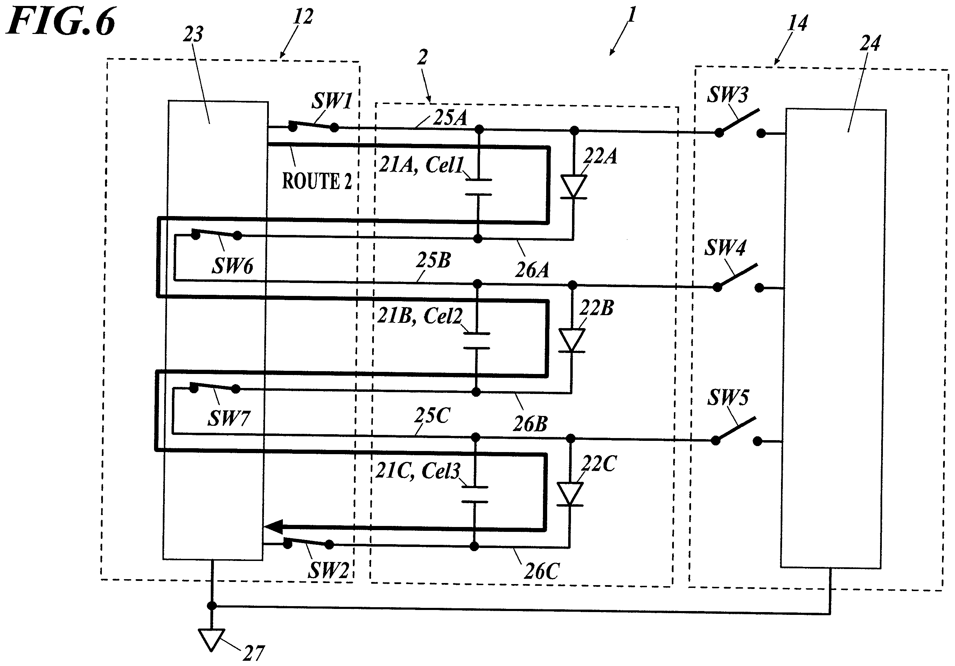

By referring to Fig. 6, it will be described the emission control route in the emission term of Embodiment 1 as illustrated in Fig. 4.

Fig. 6 is a schematic circuit diagram illustrating an example of an emission control route during an emission term in Embodiment 1.

In an organic EL module (1) having a configuration described in Fig. 4, when the three organic EL elements (22A to 22C) are driven for emitting, SW1, SW6, SW7, and SW2 are made to be in the "ON" state, the three organic EL elements (22A to 22C) are connected to the light-emitting device driving circuit section (23) to result in emitting by giving emission driving information by applying current through the route 2 indicating with a bold line. This term to make emit the organic EL elements (22A to 22C) is called as an emission term (LT). In this emission term (LT), all of SW3 to SW5 relating to touch sensing are in the "OFF" state.

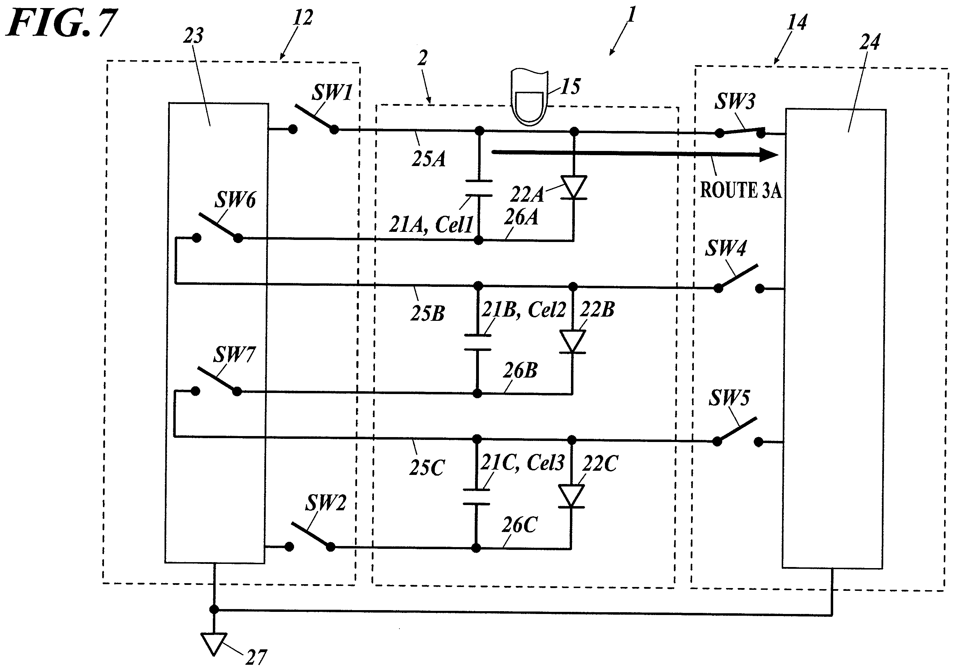

Next, in Embodiment 1 illustrated in Fig. 4, a touch sensing flow during the touch sensing term (sensing term ST) of the first to the third organic EL elements will be described by using Fig. 7 to Fig. 9.

Fig. 7 is a schematic circuit diagram illustrating an example of a touch sensing information route by a finger-touch to a first organic EL element (22A) during a sensing term (ST).

As illustrated in Fig. 7, during the sensing term (ST) conducting the touch sensing, all of SW1, SW6, SW7 and SW2 relating to the emission driving are in the "OFF" state.

In the touch sensing by finger-touch to the organic EL element (22A), the third switch (SW3) is made in the "ON" state, the touch with a finger (15) to the anode (4A) (not shown), which is a sensing electrode of the first organic EL element (22A), is detected. The touch information is announced to the touch sensing circuit section (24) of the touch sensing circuit unit (14) through the sensing information transfer rout 3A from the drawn anode lead (25A) via SW3. At this moment, since the first organic EL element (22A) and the second organic EL element (22B) are in the state of interruption by "OFF" of SW6, the touch sensing is not detected even if touch with a finger (15) is made to the anode (4B) (not shown), which is a sensing electrode of the second organic EL element (22B). Therefore, it may be avoided error sensing. Even if touch is made to the third organic EL element (22C), touch sensing is not done in the same way.

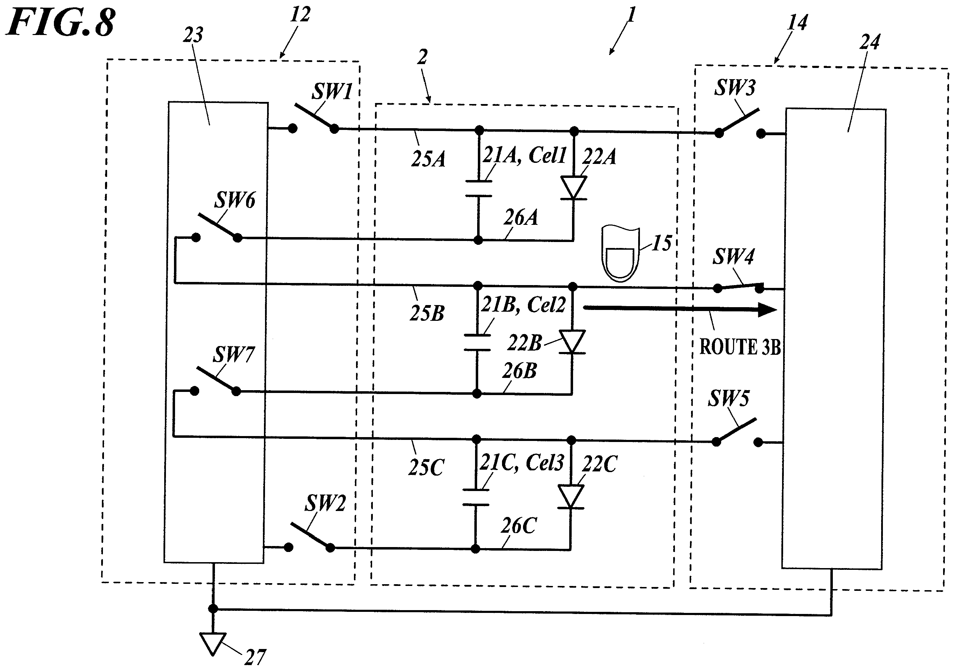

In the same way, Fig. 8 is a schematic circuit diagram illustrating an example of a touch sensing information route by a touch (finger-touch) to a second organic EL element (22B) during a sensing term (ST).

Similarly to Fig. 7, the touch sensing to the second organic EL element (22B) is done as follows. The fourth switch (SW4) is made in the "ON" state. A touch (finger-touch) is done with a finger (15) to an anode (4B) (not shown), which is a sensing electrode of the second organic EL element (22B).

The touch information is announced to the touch sensing circuit section (24) of the touch sensing circuit unit (14) through the sensing information transfer rout 3B from the drawn anode lead (25B) via SW4. At this moment, the first organic EL element (22A) and the second organic EL element (22B) are in the state of interruption by "OFF" of SW6. In the same way, the second organic EL element (22B) and the third organic EL element (22C) are in the state of interruption by "OFF" of SW7. Therefore, even if touch is made to the first organic EL element (22A) or the third organic EL element (22C), touch sensing is not done.

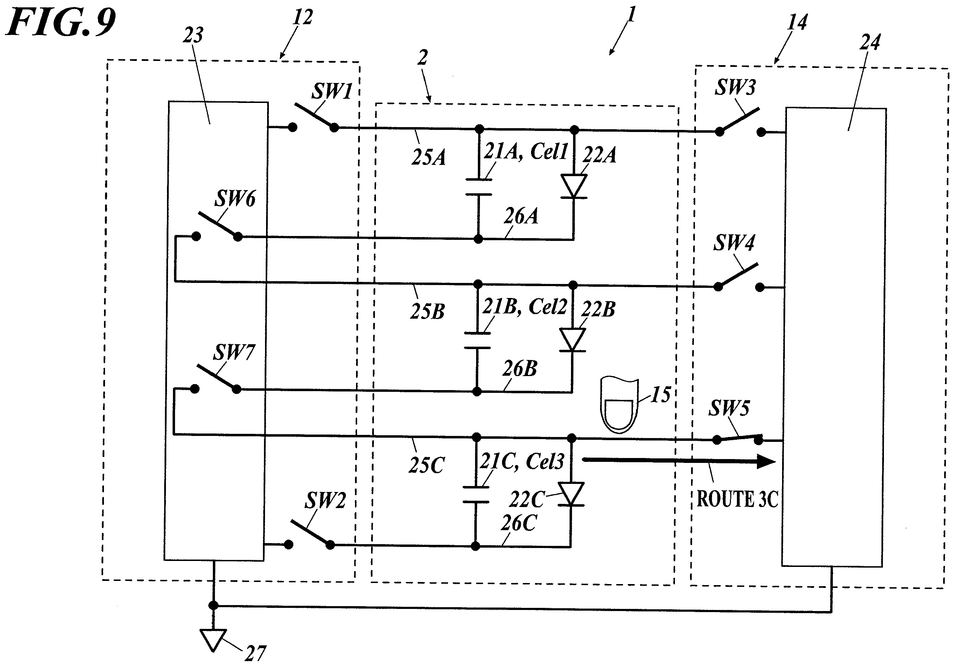

In the same way, Fig. 9 is a schematic circuit diagram illustrating an example of a touch sensing information route by a touch (finger-touch) to a third organic EL element (22C) during a sensing term (ST).

Similarly to Fig. 7, the touch sensing to the third organic EL element (22C) is done as follows. The fifth switch (SW5) is made in the "ON" state. A touch (finger-touch) is done with a finger (15) to an anode (4C) (not shown), which is a sensing electrode of the third organic EL element (22C).

The touch information is announced to the touch sensing circuit section (24) of the touch sensing circuit unit (14) through the sensing information transfer rout 3C from the drawn anode lead (25C) via SW5. At this moment, the second organic EL element (22B) and the third organic EL element (22C) are in the state of interruption by "OFF" of SW7. Therefore, even if touch is made to the second organic EL element (22B), touch sensing is not done in the same way.

Next, the time-series operation of the emission term and the sensing term (touch sensing term) in Embodiment 1 described above will now be described with reference to a timing chart.

Fig. 10 is a timing chart of pattern 1 illustrating an emission term (LT) and a sensing term (ST) in Embodiment 1.

Regarding the organic EL module (1) in Embodiment 1 having the circuit configuration illustrated in Figs. 4 to 9, the emission term (LT) of the organic EL panels 22A to 22C is controlled by an ON/OFF control of the first switch (SW1), the second switch (SW2), the sixth switch (SW6), and the seventh switch (SW7) through the light-emitting device driving circuit unit (12). The above-described switches each are made to be in the "OFF" state, the touch sensing term (ST) of each organic EL element is controlled by an ON/OFF control of the third switch (SW3), the fourth switch (SW4), the fifth switch (SW5) through the touch sensing circuit unit (14). This will achieve a touch sensor function in an icon region.

In the uppermost column of the timing chart of pattern 1 in Fig. 10 illustrates the ON/OFF operation timing of SW1, SW2, SW6 and SW7 in the light-emitting device driving circuit unit (12). In the following columns are illustrated the operation timings of SW3, SW4 and SW6 in the touch sensing circuit unit (14). In these timing charts, the high signal terms indicate that the switches are in the "ON" state. The same is applied to the timing charts described below.

The chart in the lowermost column illustrates the history of the applied voltage to the organic EL elements (22A to 22C) . When SW1, SW2, SW6 and SW7 are in the "ON" state, the voltage increases from the OLED off voltage to a certain voltage required for light-emission, so that the light emission starts. Subsequently, when SW1, SW2, SW6 and SW7 are in the "OFF" state, the current supply to the organic EL elements (22A to 22C) is stopped to stop the light emission. The light is not instantly quenched after the turning-off of SW1, SW2, SW6 and SW7, and light is still emitted for a predetermined term depending on an OLED charge/discharge time constant τ.

On the other hand, SW3 is a switch that controls the operation of the touch sensing circuit unit (14) of the first organic EL element (22A). It is made to be in the "OFF" state, when SW1, SW2, SW6 and SW7 are in the "ON" state. After making SW1, SW2, SW6 and SW7 to be in the "OFF" state, SW3 is made to be in the "ON" state, and the touch sensing is performed. At this moment, SW6 located between the first organic EL element (22A) and the second organic EL element (22B) is in the "OFF" state. Therefore, even if touch (finger-touch) is made to the second organic EL element (22B), touch sensing to the first organic EL element (22A) is not done. Thus, error sensing will be prevented.

It should be noted that SW3 is made to be in the "ON" state after a predetermined waiting term (t1) after making SW1, SW2, SW6 and SW7 to be in the "OFF" state. The OLED charge/discharge time constant in the waiting term (t1) is preferably within the range of about 0τ to 5τ.

Then, after making SW3 to be in the "OFF" state, SW3 being a switch that controls the operation of the touch sensing circuit unit (14) of the first organic EL element (22A), SW4 is made to be in the "ON" state, SW4 being a switch that controls the operation of the touch sensing circuit unit (14) of the second organic EL element (22B). Thus, touch sensing by the second organic EL element is performed.

Lastly, after making SW4 to be in the "OFF" state, SW4 being a switch that controls the operation of the touch sensing circuit unit (14) of the second organic EL element (22B), SW5 is made to be in the "ON" state, SW5 being a switch that controls the operation of the touch sensing circuit unit (14) of the third organic EL element (22C). Thus, touch sensing by the third organic EL element is performed.

In the timing chart of pattern 1 illustrated in Fig. 10, the term from the "ON" state to the "OFF" state of SW1, SW2, SW6, and SW7 is referred to as an emission term (LT), and the term from the "OFF" state of SW1, SW2, SW6, and SW7 to the "ON" state of SW3, SW4 and SW5 after the waiting term (t1) for touch detection is referred to as a sensing term (ST). The term "LT + ST" is referred to as one frame term (1FT).

The emission term (LT), the sensing term (ST), and one frame term (1FT) for the organic EL module of the present invention each may have any value, and an appropriate value may be selected depending on the environment. For example, the emission term (LT) of the OLED may be in the range of 0.1 to 2.0 msec., the sensing term (ST) may be in the range of 0.05 to 0.3 msec. , and the one frame term (1FT) may be in the range of 0.15 to 2.3 msec. The frame terms preferably have a frequency of 60 Hz or greater to reduce flicker.

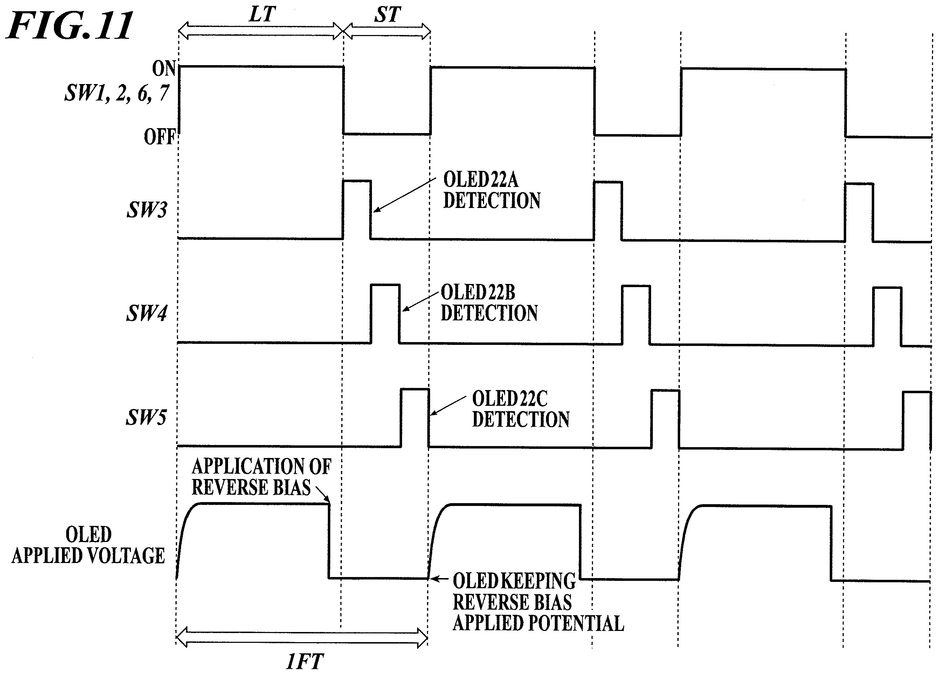

Fig. 11 is a timing chart of pattern 2 illustrating another exemplary emission term and sensing term in Embodiment 1 in which a reverse applied voltage is applied to the organic EL element.

In contrast to the pattern of voltage application to the OLED illustrated in the lowermost column of Fig. 10, after making SW1, SW2, SW6, and SW7 in the "ON" state, a reverse applied voltage is applied to across the anode (4) and the cathode (6) at the end of the emission term immediately before the turning-off of SW1, SW2, SW6, and SW7 to prevent charge and discharge at the turned-off time of the OLED in the timing chart illustrated in Fig. 11. Thus, the SW3 pattern that conducts touch sensing to the first organic EL element does not require to have a waiting term (t1) as illustrated in Fig. 10.

### (Embodiment 2)

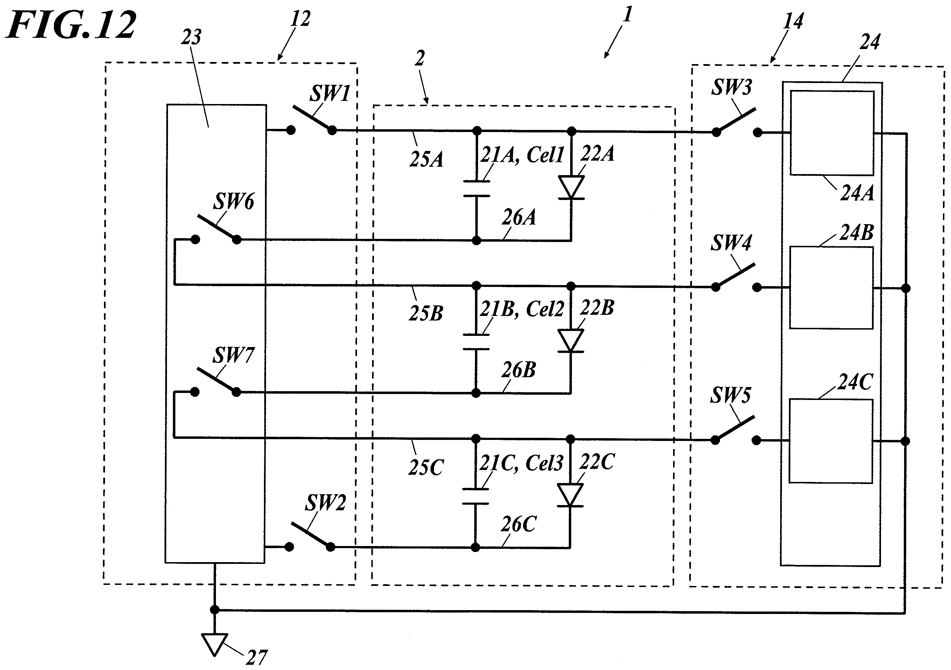

Fig. 12 is a driving circuit diagram in Embodiment 2 of an organic EL module of the present invention. The organic EL module contains three organic EL elements having a switch therebetween, and the organic EL elements each respectively have a touch sensing circuit section.

The basic circuit configuration is the same configuration as described for Fig. 4 to Fig. 11. However, in the touch sensing circuit section (24) composing the touch sensing circuit unit (14), there are placed a first organic EL element (22A), an anode lead (25A), and independently a first touch sensing circuit section (24A) in SW3 line. In the same way, there are placed a second organic EL element (22B), an anode lead (25B), and independently a second touch sensing circuit section (24B) in SW4 line. And further, there are placed a third organic EL element (22C), an anode lead (25C), and independently a third touch sensing circuit section (24C) in SW5 line.

As illustrated in Fig. 12, each touch sensing circuit has an independent touch sensing circuit section. By this, the sensing circuit side can operate touch sensing in a parallel state. As a result, the sensing term may be made to be identical.

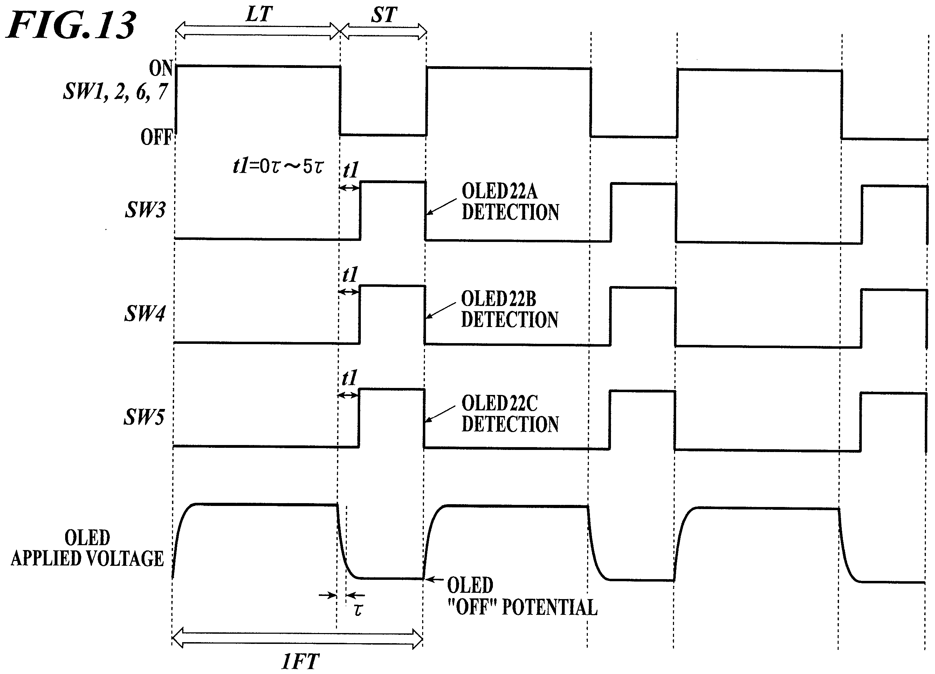

Fig. 13 is an exemplary timing chart illustrating an emission term and a sensing term in Embodiment 2.

In the timing chart illustrated in Fig. 13, the operation of the light-emitting device driving circuit unit (12) of the organic EL element has the same timing chart as illustrated in Fig. 10 relating to Embodiment 1 as described above. However, in Embodiment 1, the touch sensing is performed from the organic EL elements 22A to 22C with the sensing term (ST) in a time-series operation. On the other hand, in Embodiment 2, the touch sensing to the organic EL element may be performed in parallel within the same term by installing an independent touch sensing circuit section (24A to 24C).

### (Embodiment 3)

In the organic EL module of the present invention, it is preferable that at least one of the paired electrodes is in a floating potential during the touch sensing term to prevent detection of the capacitance of the respective organic electroluminescent element. Further it is preferable that at least one of the paired electrodes is in a floating potential and the paired electrodes are short-circuited during the touch sensing term to prevent detection of the capacitance of the respective organic electroluminescent panel. Still further, it is preferable that both of the paired electrodes are in a floating potential.

In the organic EL module of the present invention, the light-emitting device driving circuit unit and the touch sensing circuit unit are independently installed. At the moment of touch sensing, in order to prevent detection of the electrostatic capacitance Cel between the anode and the cathode, the switch is turned off between the anode, the cathode, and the light-emitting device driving circuit section, and at least one of the anode and the cathode, or both of the electrodes are made to be in a floating potential. By this, it is possible to perform touch sensing. As a result, it may achieve a small format and a small thickness, and simplified process,

In the present invention, as described above, a floating potential state is a state of not connected to a ground of a power source of an apparatus. Since the anode or the cathode is in the floating potential at touch detection, a finger-touch may be detected without detection of the interelectrode capacitance Cel of the organic EL panel.

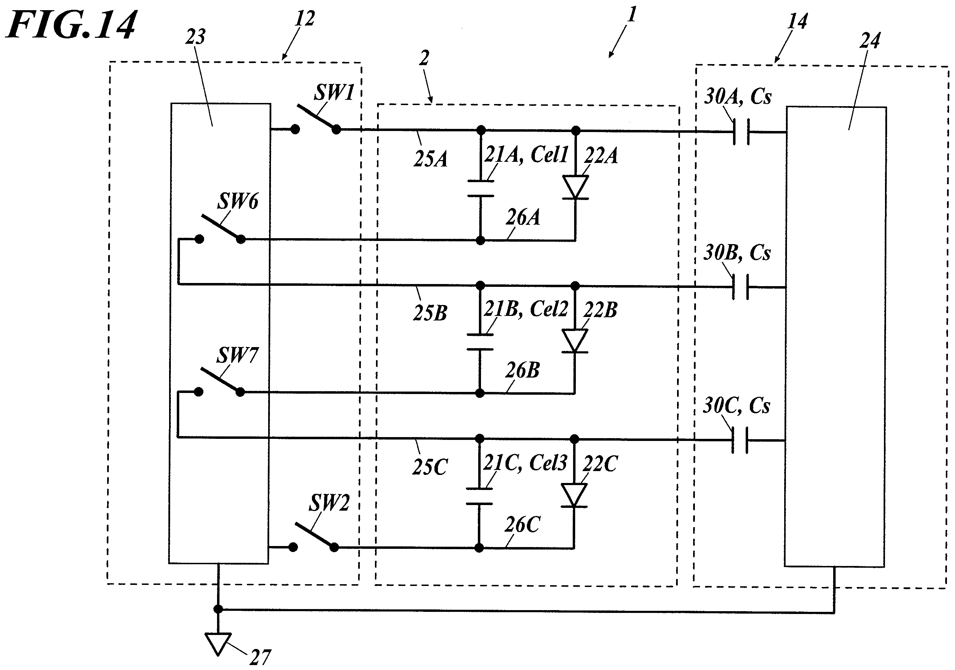

Fig. 14 is a driving circuit diagram illustrating another exemplary organic EL module in Embodiment 3.

In contrast to the driving circuit diagram of Embodiment 1 as illustrated in Fig. 4, Embodiment 3 illustrated by Fig. 14 has a configuration of including a capacitor Cs (30A to 30C) instead of the third switch to the fifth switch (SW3 to SW5) composing the touch sensing circuit unit (14). By incorporating the capacitor Cs (30A to 30C) in the circuit, it may be given the same function as the third switch to the fifth switch (SW3 to SW5).

In Embodiment 3, the light-emitting device driving circuit section (23) may include the first switch (SW1) and/or the second switch (SW2) therein. The touch sensing circuit section (24) may include the capacitor Cs (30) therein.

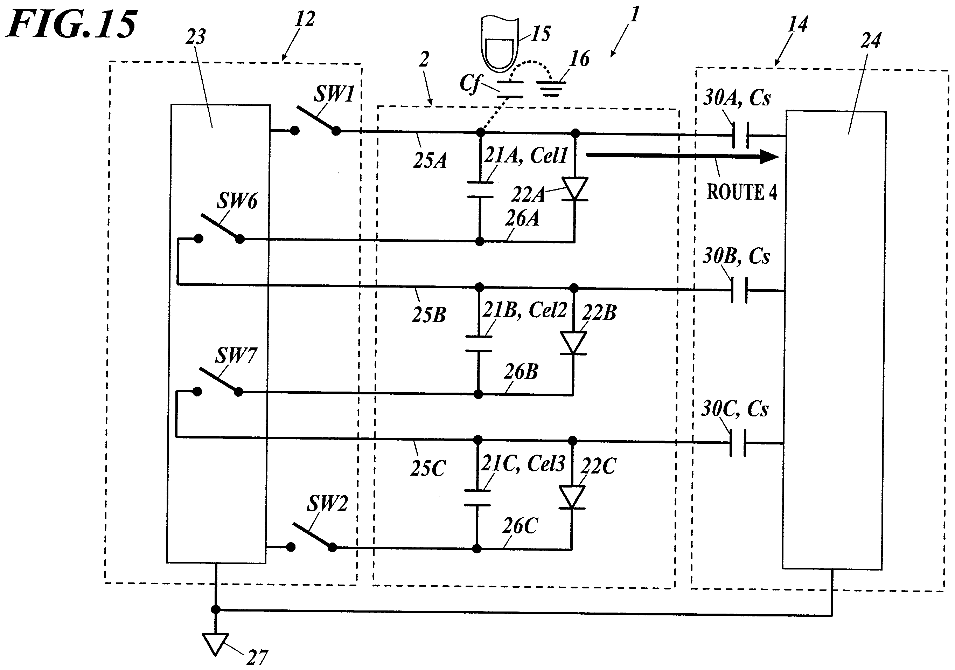

Fig. 15 is a schematic circuit diagram illustrating an example of a touch sensing information route by a touch (finger-touch) to a first organic EL element as an example of a sensing term in Embodiment 3.

While making SW1, SW6, SW7, and SW2 of the light-emitting device driving circuit unit (12) to be in the "OFF" state, and the light-emitting device driving circuit section (23) is in the open state, the surface of the glass substrate of anode (4A) (not shown), which is a sensing electrode, is touched. By this action, an electrostatic capacitance Cf is produced between the finger (15) and the anode (sensing electrode). The touch sensing is performed by using this electrostatic capacitance. The electrostatic capacitance Cf is connected to an earth 16 (ground). The route 4 is a touch sensing information route at the moment of sensing.

At this moment, SW1 is in the "OFF" state, and the paired electrodes are in a floating potential state in which capacitance is not detected, therefore, it is possible to perform touch sensing.

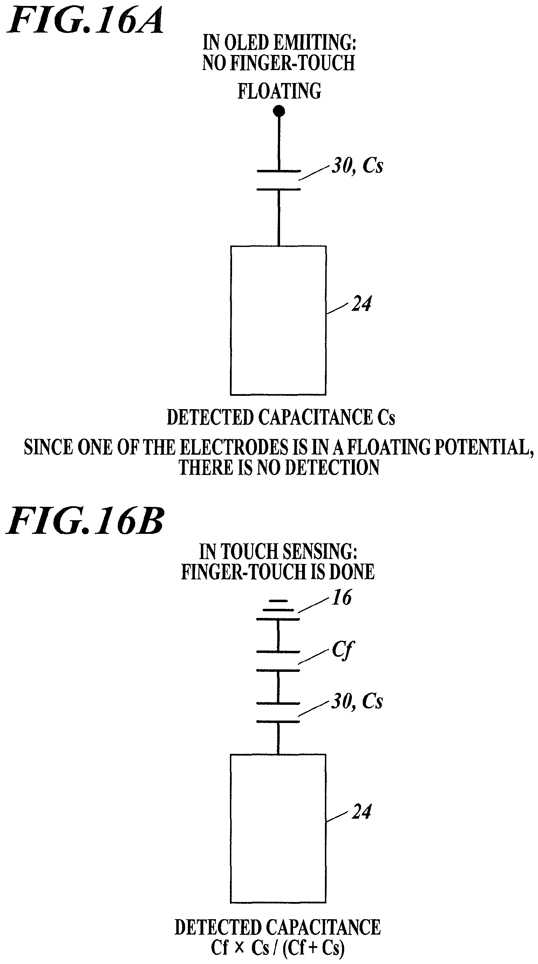

Figs. 16A is a schematic diagrams illustrating the difference in capacitance between in the emission term and in the sensing term (during finger-touch) at the emission time of the organic EL element in Embodiment 3. Figs. 16B is a schematic diagrams illustrating the difference in capacitance between in the emission term and in the sensing term (during finger-touch) at the touch sensing time of the organic EL element in Embodiment 3.

As illustrated in Fig. 16A, when a touch (finger-touch) is not done, since one of the electrodes is in the floating potential condition, the capacitance Cs installed in the touch sensing circuit unit (14) is not detected. On the other hand, as illustrated in Fig. 16B, when a touch (finger-touch) sensing is carried out, the electrostatic capacitance will be as follows. The series capacitance formed with the electrostatic capacitance Cf (produced by the finger (15) and the anode (4) that is a touch sensing electrode) and the capacitor Cs (30) becomes "Cf x Cs / (Cf + Cs)". As a result, the touch (finger-touch) will be detected.

### (Embodiment 4)

In the organic EL module of the present invention, it is preferable that the touch sensing circuit unit (14) and the light-emitting device driving circuit unit (12) each are connected to an independent ground. When viewed from the touch sensing circuit unit (14) side, the touch electrode has substantially no effect by the capacitance of the organic EL element. Only the capacitance formed with the finger and the sensing electrode is detected. This embodiment has a preferable composition in view of improving the touch sensing sensitivity.

Fig. 17 is a driving circuit diagram in Embodiment 4 having a configuration of placing a switch between three organic EL elements in an organic EL module and having an independent ground to the touch sensing circuit unit and to the light-emitting driving circuit unit respectively.

The driving circuit diagram illustrated in Fig. 17 has basically the same configuration as described for Fig. 4 in Embodiment 1. A first ground (27A) is placed to the light-emitting device driving circuit section (23) composing the light-emitting device driving circuit unit (12). On the other hand, a second ground (27B) is placed to the touch sensing circuit section (24) composing the touch sensing circuit unit (14). It has a composition of having the light-emitting device driving circuit unit (12) and the touch sensing circuit section (24) independently.

The timing chart of the emitting term and the sensing term in the organic EL module having two grounds in Embodiment 4 is the same as the timing chart indicated in Fig. 10 and Fig. 11. Here, the description is omitted.

### (Embodiment 5)

In the organic EL module of the present invention, a resistor (Ra) is placed at the connecting portion of the two or more organic EL elements laid out in series. By the time constant (Ra·Cel) formed with the resistor (Ra) and the organic EL element capacitance (Cel), the independent detection device is incorporated for the touch (finger-touch) to respective EL element. This is a preferable method to prevent error sensing.

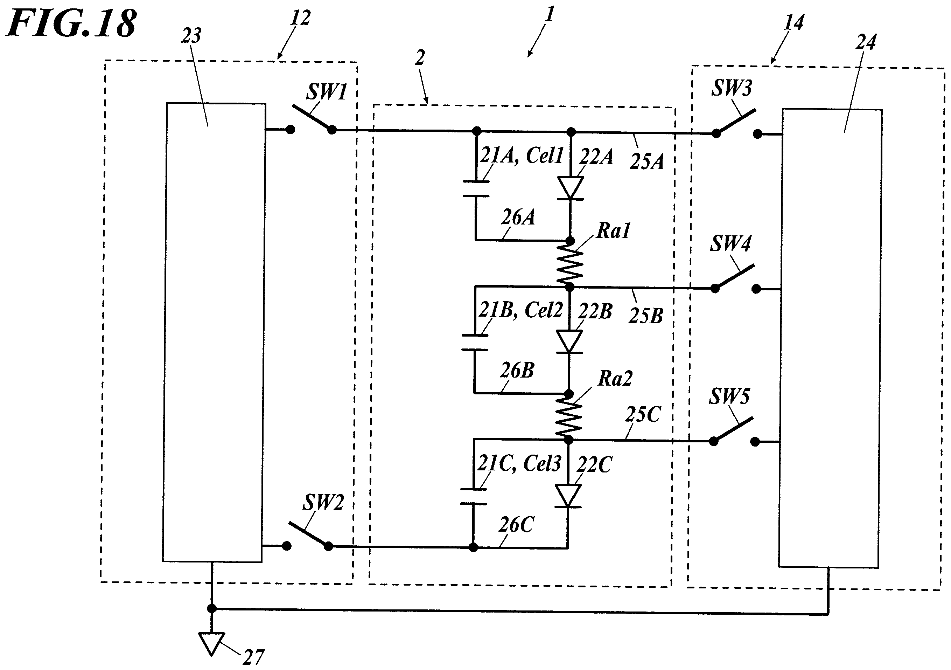

Fig. 18 is a driving circuit diagram in Embodiment 5 having a configuration provided with a resistor between three organic EL elements composing an organic EL module.

In the driving circuit diagram as illustrated in Fig. 18, the touch sensing circuit unit (14) has the same configuration as described for Embodiment 1 (Fig. 4, for example).

As a configuration of the light-emitting device driving circuit unit (12) and the organic EL panel (2), Embodiment 1 is characterized in that the switches (SW6 and SW7) are installed between the organic EL elements to prevent error sensing. On the other hand, in Embodiment 5 illustrated in Fig. 18, it is characterized in having the following composition instead of the switches (SW6 and SW7). A resistor (Ra1) is located between the cathode lead (26A) of the first organic EL element (22A) and the anode lead (25B) of the second organic EL element (22B). Likewise, a resistor (Ra2) is located between the cathode lead (26B) of the second organic EL element (22B) and the anode lead (25C) of the third organic EL element (22C).

In the configuration of Embodiment 5, during the emitting term of the organic EL element (during the lighting term of OLED), SW1 and SW2 are made in the "ON" state, and the emitting circuit is formed. Thus the organic EL elements (22A to 22C) are made to be lighted.

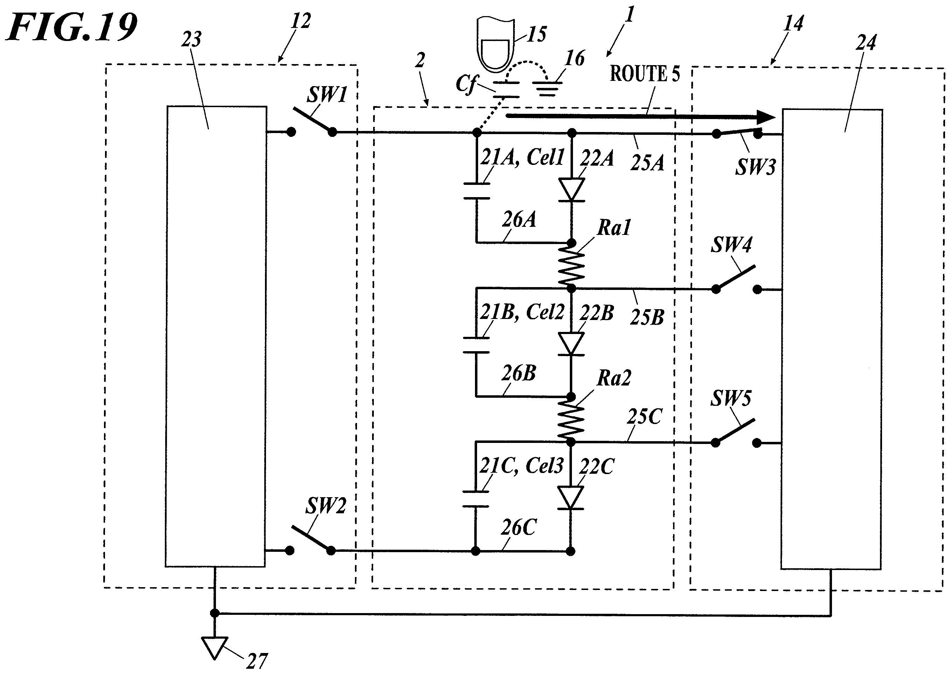

The driving circuit in the sensing term (ST) of Embodiment 5 illustrated in Fig. 18, and the error sensing preventing mechanism of the touch (finger-touch) will be described by using Fig. 19 to Fig. 22.

Fig. 19 is a schematic circuit diagram illustrating a normal sensing route by a touch (finger-touch) to a first organic EL element (22A) in the sensing term of the first organic EL element (22A) in Embodiment 5.

As illustrated in Fig. 19, the normal sensing route (route 5) is done as follows. While making SW3 to be in the "ON" state, a touch (finer-touch) is done to the anode (4A) (not shown) served as a touch sensing electrode and connected to the anode lead (25A) of the first organic EL element (22A). Thus normal touch sensing is carried out.

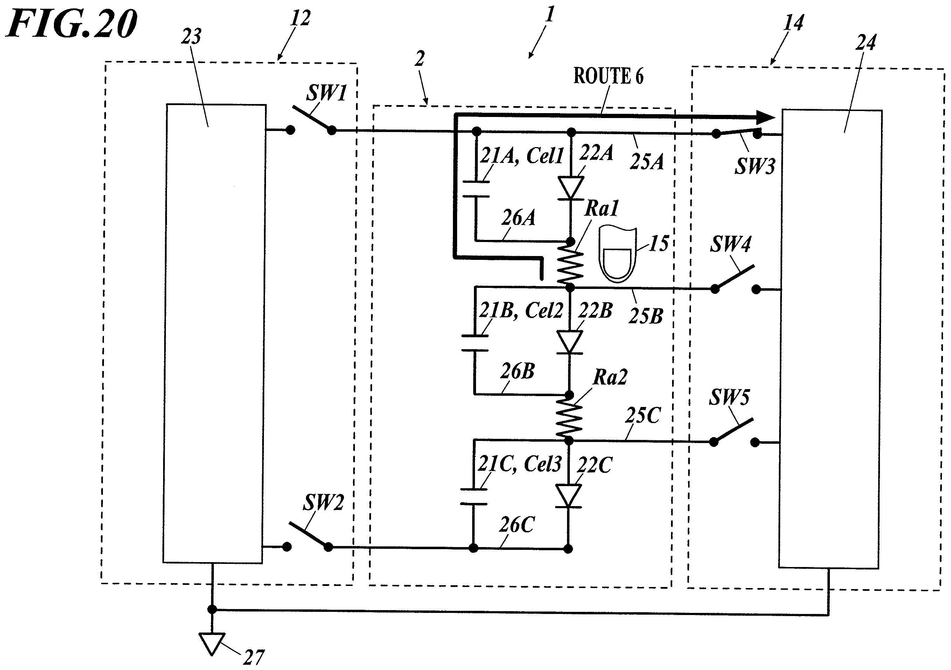

On the other hand, as illustrated in Fig. 20, when a touch (finer-touch) is done to the anode (4B) (not shown) served as a touch sensing electrode of the second organic EL element (22B), the touch sensing information route becomes the following route 6. The error sensing information is transferred as if the first organic EL element (22A) was touched through the route of: anode (4B) (not shown) → resistor (Ra1) → cathode lead (26A) → capacitor 21A (Cel 1) → anode lead (25A) → SW3 → touch sensing circuit section (24).

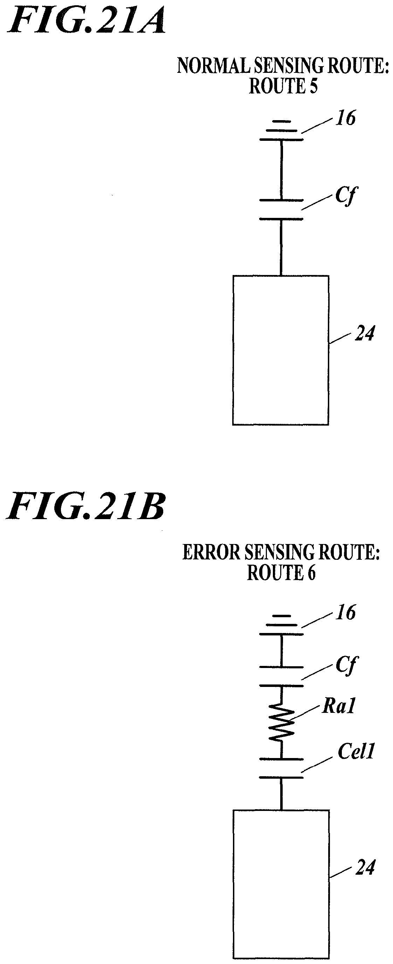

A differential capacitance of a normal sensing route and an error sensing route in Embodiment 5 is described in Fig. 21.

Fig. 21A is a schematic diagram illustrating a differential capacitance of a normal sensing route (route 5) as indicated in Fig. 19 as an example. Fig. 21B is a schematic diagram illustrating a differential capacitance of an error sensing route (route 6) as described in Fig. 20.

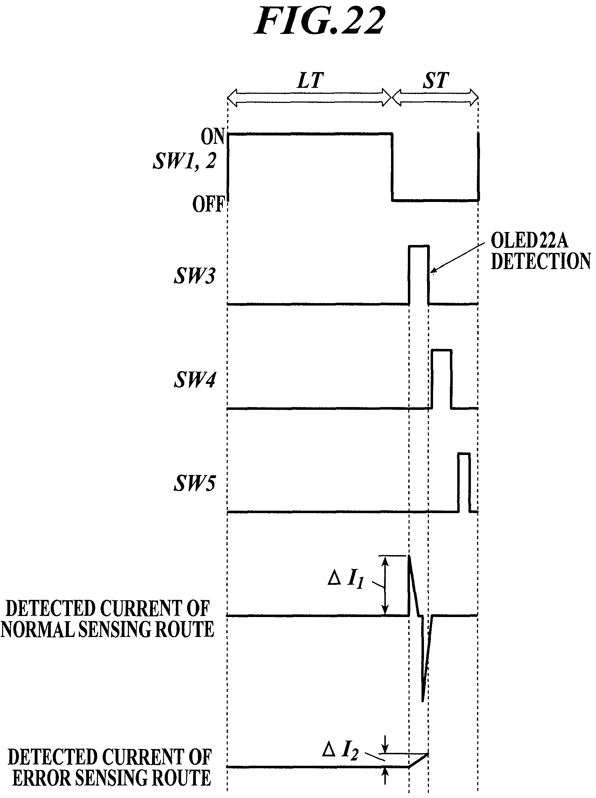

As illustrated in Fig. 21B, in the error sensing route (route 6), there exists a resistor (Ra1) in the touch sensing circuit. As a result, the time constant of the sensing current in the route 5 becomes "Ra1 x Cf". As described later in detail for Fig. 22, this time constant of the sensing current is adjusted by the resistor Ra1, and it is set to be a sufficiently long term compared with the ON term of SW3. Consequently, during the sensing term of the first organic EL element, a current value (ΔI₁) required for touch sensing is not achieved. Aa a result, even if an error touch (error finger-touch) is done to the second organic EL element (22B), the touch sensing information is not reached to the touch sensing circuit section (24) within the predetermined time. Therefore, the error sensing is not done.

The time constant of the present invention is a time required for changing to a predetermined value (electric current value necessary for sensing) among the variation (electric current value) from the initial value to the final value. In the RC circuit (resistor and capacitor) of the electronic circuit of the present invention, it is a constant representing a changing rate of the electric current from the initial stage of applying the current to achieving the steady-state current value. It is a rough indication of time required for reaching the steady-state current value. Namely, by incorporating a resistor in the circuit, there is produced a time lag for reaching the steady-state current value. If there is no resistor, the current in the route 5 immediately reaches the steady-state current value. Thus, there will be produced error sensing (conventional circuit as indicated in Fig. 2).

Fig. 22 is a timing chart for describing a time constant in Embodiment 5.

In Fig. 22, a part of timing chart in Embodiment 5 is illustrated.

In the emitting term (LT) of the organic EL element, SW1 and SW are made in the "ON" state, and an emitting circuit is formed. The organic EL elements (22A to 22C) are made to be lighted.

Next, in the sensing term (ST), SW3 to SW5 are successively made to be "ON" and "OFF", and touch sensing to the organic EL elements (22A to 22C) are performed.

When the current value at the time of touch sensing to the first organic EL element (22A) is made to be ΔI₁ through a normal sensing route (route 5), and if a touch (finger-touch) is mistakenly done to the second organic EL element (22B) while SW3 is made in the "ON" state, the detected current from the error sensing route (route 6) will be very small value ΔI₂, by making the time constant (Cell x Rf) to be sufficiently large compared with the sensing term of the first organic EL element (22A). This value ΔI₂ is insufficient value for detecting touch sensing. This means that the touch sensing is not performed and error sensing is avoided.

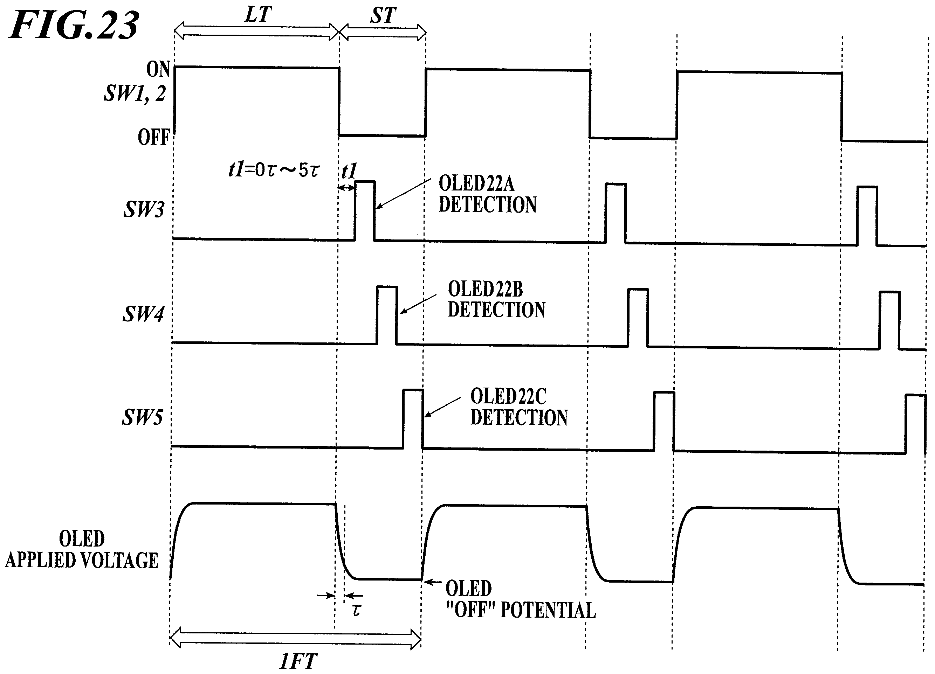

Fig. 23 is a timing chart illustrating an exemplary emission term and an exemplary sensing term in Embodiment 5. Basically, this timing chart is the same as the timing chart of Embodiment 10 described in Fig. 10.

### (Embodiment 6)

In the organic EL module of the present invention, it may be adopted a driving method in which a plurality of organic EL elements, which are controlled by the light-emitting device driving circuit section, are continuously made in the constant emission state, and the touch sensing term, which is controlled by the touch sensing circuit section, is periodically appeared.

Fig. 24 illustrates a configuration provided with a capacitor (34) between the wiring connecting the ground of the light-emitting device driving circuit section (23) and the ground of the touch sensing circuit section (24), by removing SW1 and SW2 in the circuit diagram including a resistor between the organic EL elements as described in Fig. 18 to Fig. 23.

In Fig. 24, the side of the light-emitting device driving circuit unit (12) has no switch. The light-emitting control circuit is continuously in the connected state. The organic EL elements (22A to 22C) are in the state of continuously emitting light.

On the other hand, the touch sensing circuit unit (14), which is illustrated on the right of the drawing, may independently perform touch sensing in the same manner as described in Fig. 18 to Fig. 23.

Namely, Fig. 24 indicates as follows. SW3 in the touch sensing circuit unit (14) is made in the "ON" state, and a finger (15) touches the upper surface of the glass substrate of the anode (4A) (not shown) serving as a sensing electrode of the organic EL panel (22A). By this touch, there is produced an electrostatic capacitance Cf between the finger (15) and the anode (4A) serving as a sensing electrode. Thus the touch (finger-touch) may be detected.

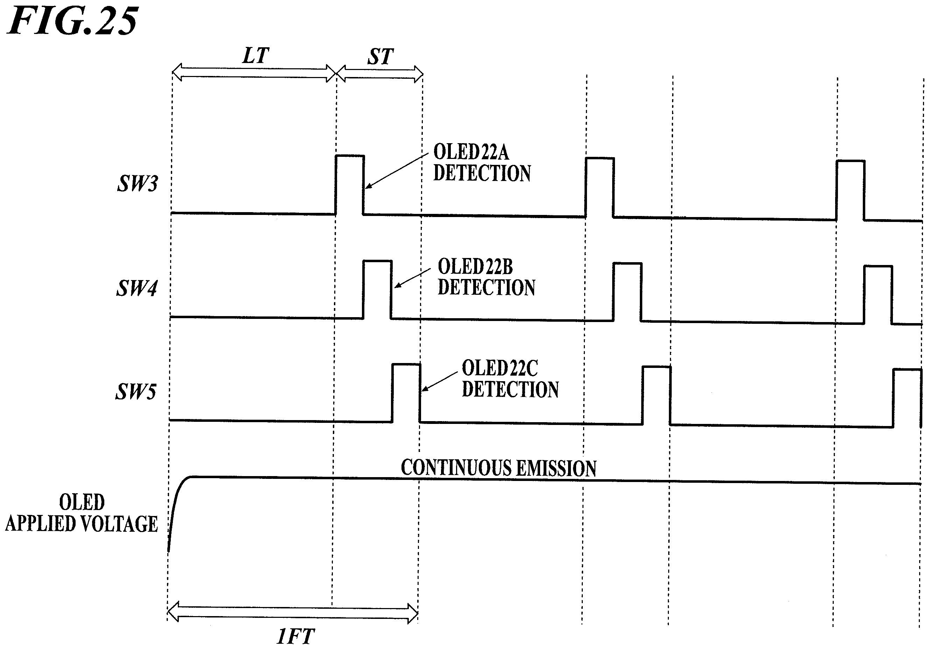

Fig. 25 is a timing chart formed with a continuous emission term and a sensing term by the organic EL elements (22A to 22C) in Embodiment 6. As indicated in Fig. 24, there are no SW1 and SW2. The circuit is in the continuously connected state. As a result, the applied voltage to the OLED is continuously in the "ON" state, and the OLED continuously emits light. Against this, the touch sensing may be periodically performed by sequentially making SW3 to SW5 of the touch sensing circuit unit (14) in the "ON/OFF" state.

### (Embodiment 7)

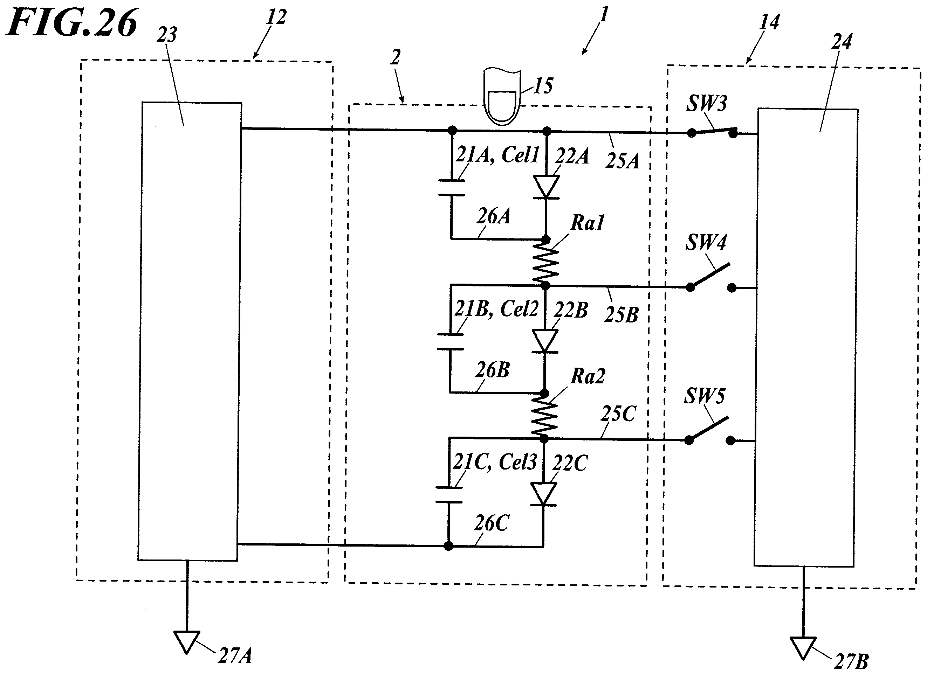

Fig. 26 is a driving circuit drawing of Embodiment 7 illustrating another exemplary organic EL module in which an organic EL element is continuously emitted.

In contrast to the configuration of Fig. 24 as described above, the organic EL module (1) of Fig. 26 has a configuration provided with an independent ground (27A and 27B) to the light-emitting device driving circuit unit (12) and the touch sensing circuit unit (14) instead of the capacitor (34).

In Embodiment 7, the timing chart formed with the continuous emitting term and the sensing term by the organic EL elements 22A to 22C is the same as the timing chart illustrated in Fig. 25 as described above.

### (Embodiment 8: Another exemplary configuration of organic EL module: the case in which touch sensing electrode is cathode)

As illustrated in Fig. 3 to Fig. 26, the anode functions as a touch sensing electrode. Alternatively, the cathode (6) may function as a touch sensing electrode.

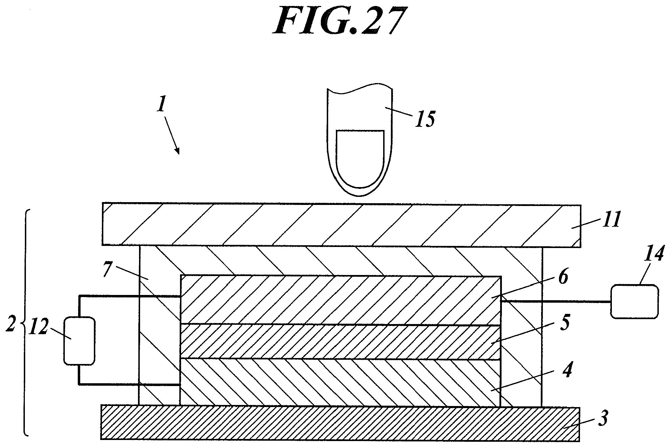

Fig. 27 is a schematic cross-sectional view of another exemplary organic electroluminescent module of the present invention that includes a cathode functioning as a touch sensing electrode.

In contrast to the organic EL module of Fig. 3 including the anode (4) functioning as a touch sensing electrode, the organic EL module of Fig. 27 includes a cathode (6) functioning as a touch sensing electrode. The cathode (6) is connected to the touch sensing circuit unit (14), and the surface of the cathode (6) is touched by a finger (15) for the touch sensing.

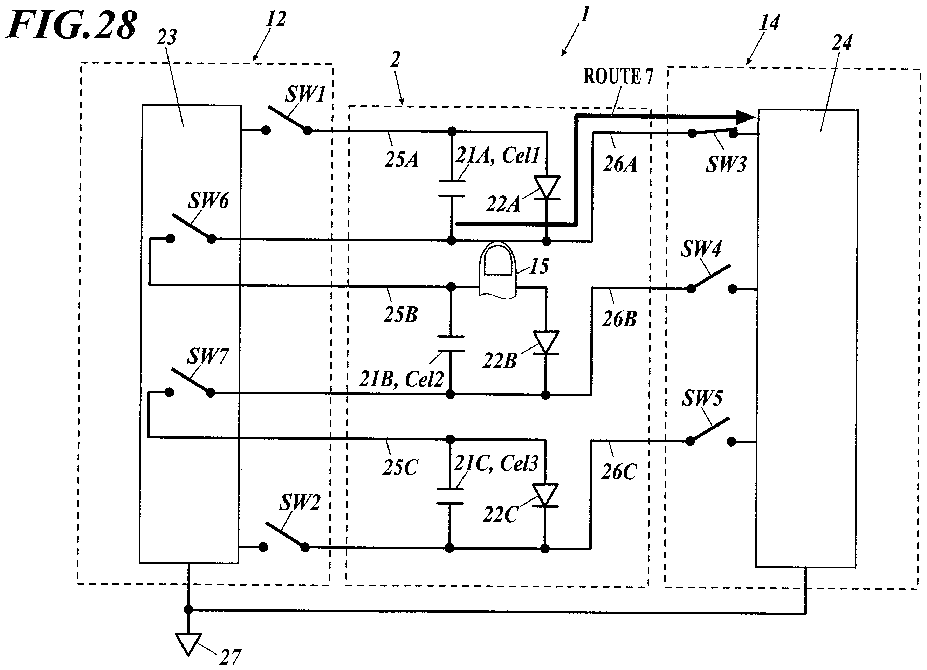

Fig. 28 is a driving circuit diagram of an organic EL module of Embodiment 8 that includes a cathode functioning as a touch sensing electrode. In contrast to the driving circuit diagram of Embodiment 1 illustrated in Fig. 4 to Fig. 11, the wiring of the touch sensing circuit section (14) is connected to the cathode lead (26A to 26C) via the each switch, and the other constitution is the same as illustrated in Fig. 4.

Fig. 28 illustrates an example of touch sensing in which touch (finger-touch) is made with a finger (15) to the cathode (26A) of the first organic EL element (22A). By the touch (finger-touch) with a finger (15), the touch sensing is carried out according to the touch sensing information route 7: the cathode (26A) → SW3 → the touch sensing circuit section (24).

### «Configuration of organic EL panel»

The organic EL panel (2) of the organic EL module (1), as shown in Fig. 2, includes an emission region composed of an anode (4A) and an organic functional layer unit (5) laminated on a transparent substrate (3). A cathode (6) is disposed on the organic functional layer unit (5) to give an organic EL element. The periphery of the organic EL element is sealed with a sealing adhesive (7) and a sealing member (8) is disposed thereon. Thus the organic EL panel (2) is configured.

Typical configurations of the organic EL element are listed below:
(i) anode / (hole injection transport layer) / (luminous layer) / (electron injection transport layer) / cathode
(ii) anode / (hole injection transport layer) / (luminous layer) / (hole blocking layer) / (electron injection transport layer) / cathode
(iii) anode / (hole injection transport layer) / (electron blocking layer) / (luminous layer) / (hole blocking layer) / (electron injection transport layer) / cathode
(iv) anode /(hole injection layer) / (hole transport layer) / (luminous layer) / (electron transport layer) / (electron injection layer) / cathode
(v) anode / (hole injection layer) / (hole transport layer) / (luminous layer) / (hole blocking layer) / (electron transport layer) / (electron injection layer) / cathode
(vi) anode / (hole injection layer) / (hole transport layer) / (electron blocking layer) / (luminous layer) / (hole blocking layer) / (electron transport layer) / (electron injection layer) / cathode.

Further, a nonluminous intermediate layer may be provided between the luminous layers. The intermediate layer may be an electron generating layer or may have a multiphoton emission structure.

The detailed configurations of the organic EL elements applicable to the present invention are disclosed in, for example, Japanese Unexamined Patent Application Publication Nos. 2013-157634, 2013-168552, 2013-177361, 2013-187211, 2013-191644, 2013-191804, 2013-225678, 2013-235994, 2013-243234, 2013-243236, 2013-242366, 2013-243371, 2013-245179, 2014-003249, 2014-003299, 2014-013910, 2014-017493, and 2014-017494.

Individual layers of the organic EL element of the present invention will now be described in sequence.

### (Transparent substrate)

Examples of the transparent substrate (3) applicable to the organic EL element of the present invention include transparent materials, such as glass and plastics. Preferred transparent substrates (3) include glass, quartz, and resin films. In the present invention, "transparent" indicates the property having an average transparency in the visible region is 60% or more, more preferably, 70% or more, still more preferably, 80% or more.

Examples of the glass materials include silica glass, soda lime silica glass, lead glass, borosilicate glass, and non-alkali glass. The surface of each glass material may be subjected to physical treatments such as polishing or may be covered with a thin organic or inorganic film or a thin hybrid film formed by combination of thin organic and inorganic films, in view of adhesiveness to the adjoining layer and durability and smoothness of the material.

Examples of the material for the resin film include polyesters, such as poly(ethylene terephthalate) (PET) and poly(ethylene naphthalate) (PEN); polyethylene; polypropylene; cellophane; cellulose esters and derivatives thereof, such as cellulose diacetate, cellulose triacetate (TAC), cellulose acetate butyrate, cellulose acetate propionate (CAP), cellulose acetate phthalate, and cellulose nitrate; poly(vinylidene chloride); poly(vinyl alcohol); poly(ethylene-vinyl alcohol); syndiotactic polystyrene; polycarbonates; norbornene resins; polymethylpentene; polyether ketones; polyimides, polyether sulfones (PESs); poly(phenylene sulfide); polysulfones; polyether imides; polyether ketone imides; polyamides; fluorinated resins; nylons; poly(methyl methacrylate); acrylics and polyallylates; and cycloolefin resins, such as Arton (commercial name, available from JSR) andApel (commercial name, available from Mitsui Chemicals, Inc.).

The organic EL element may further include an optional gas barrier layer on the transparent substrate (3).

The gas barrier layer may be composed of any material that will block moisture and oxygen, which are components causing degradation of the organic EL element. Examples of such materials include inorganic compounds, such as silicon monoxide, silicon dioxide, and silicon nitride. The gas barrier layer should preferably have a layered structure composed of one or more inorganic layers and organic layers to solve the fragility of the gas barrier layer. The inorganic layers and organic layers may be laminated in any order and may be alternately laminated in a preferred embodiment.

### (Anode)

Examples of materials for the anode of the organic EL element include metals, such as Ag and Au; alloys primarily composed of such metals; CuI; indium-tin oxide (ITO) ; and metal oxides, such as SnO₂ and ZnO. Preferred are the aforementioned metals and alloys primarily composed of the metals. More preferred are silver and silver-based alloys. In the case where light is emitted from the anode, the anode should be transparent.

When a transparent anode is primarily composed of silver, the purity of silver is preferably 99% or more. In order to enhance the stability of silver, it may be added palladium (Pd), copper (Cu) or gold (Au).

The transparent anode is a layer mainly composed of silver. Specifically, it may be composed of silver alone or a silver (Ag) alloy. Examples of such alloys include silver-magnesium (Ag-Mg), silver-copper (Ag-Cu), silver palladium (Ag-Pd), silver-palladium-copper (Ag-Pd-Cu), and silver-indium (Ag-In).

Preferably the anode of the organic EL element of the present invention should be a transparent anode composed primarily of silver and having a thickness of 2 to 20 nm, more preferably 4 to 12 nm. A thickness of less than 20 nm of the transparent anode reduces absorption and reflection of light and thus achieves high light transmittance.

In the present invention, the term "a layer primarily composed of silver" indicates that the transparent anode contains silver in an amount of 60 mass% or more, preferably 80 mass% or more, more preferably 90 mass% or more, most preferably 98 mass% or more. The term "transparent" used for the anode in the present invention refers to a light transmittance of 50% or more at a wavelength of 550 nm.

The transparent anode may be composed of two or more silver-based layers according to demand.

In the present invention, a silver-based transparent anode may be underlain by a foundation layer to enhance the uniformity of the transparent silver anode. The foundation layer may be composed of any material, preferably an organic compound containing a nitrogen or sulfur atom. Preferably a transparent anode is formed on the foundation layer.

### (Intermediate electrode)

The organic EL element of the present invention may include two or more organic functional layer units each consisting of an organic functional layer group and a luminous layer and disposed between an anode and a cathode. Two adj acent organic functional layer units are separated by an intermediate electrode layer having a connection terminal for electrical connection.

### (Luminous layer)

The luminous layer of the organic EL element should preferably contain a luminous material, such as a phosphorescent or fluorescent material.

In the luminous layer, electrons injected from an electrode or electron transport layer and holes injected from a hole transport layer recombine to emit light. Light may be emitted in the luminous layer or at an interface between the luminous layer and the adjoining layer.

The luminous layer may be composed of any luminous material satisfying luminescent requirements. The luminous layer may be composed of two or more sublayers having the same emission spectrum and maximum emission wavelength. In this case, a non-luminescent intermediate layer should be preferably disposed between two adjacent luminous sublayers.

The total thickness of the luminous layer should preferably ranges from 1 to 100 nm, more preferably from 1 to 30 nm to reduce the driving voltage. The total thickness includes the thickness(es) of the optional non-luminescent intermediate layer (s) disposed between the luminous sublayers.

The luminous layer may be formed with luminous materials and host compounds, which will be described below, by any known process, such as vacuum evaporation, spin coating, casting, LB (Langmuir-Blodgett) coating, or ink jetting.

The luminous layer may be composed of two or more luminous materials, for example, a mixture of a phosphorescent material and a fluorescent material (also referred to as a fluorescent dopant or fluorescent compound). In a preferred embodiment, the luminous layer contains a host compound (also referred to as a luminescent host) and a luminous material (also referred to as a luminescent dopant) so that the luminous material emits light.

### <Host compound>

Preferred host compounds to be compounded in the luminous layer have a phosphorescence quantum yield of less than 0.1 at room temperature (25 °C), more preferably less than 0.01. The volume fraction of the host compound is preferably 50% or more in the luminous layer.

Any known host compound may be used. The host compounds may be used alone or in combination. Use of two or more host compounds facilitates the adjustment of charge transfer and thus enhances the efficiency of the organic electroluminescent device. Use of two or more luminous materials that emit different colors facilitates emission of light with a desired color.

The host compounds used in the luminous layer may be any known low-molecular-weight compound, any polymer having repeating units, or any low-molecular weight compound having a polymerizable group, for example, a vinyl or epoxy group (evaporation-polymerizable luminescent host).

The host compounds usable in the present invention are disclosed in, for example, Japanese Unexamined Patent Application Publication Nos. 2001-257076, 2001-357977, 2002-8860, 2002-43056, 2002-105445, 2002-352957, 2002-231453, 2002-234888, 2002-260861, and 2002-305083; United States Patent Application Nos. 2005/0112407 and 2009/0030202; WO 2001/039234, WO 2008/056746, WO 2005/089025, WO 2007/063754, WO 2005/030900, WO 2009/086028, and WO 2012/023947; Japanese Unexamined Patent Application Publication No. 2007-254297; and EP 2034538.

### <Luminous material>

Examples of the luminous material usable in the present invention include phosphorescent compounds (also referred to as phosphorescent materials or phosphorescent dopants) and fluorescent compounds (also referred to as fluorescent materials).

### <Phosphorescent compound>

Phosphorescent compounds involve light emission from the excited triplet state, emit phosphorescent light at room temperature (25 °C), and have a phosphorescent quantum yield of 0.01 or more at 25 °C. The phosphorescent quantum yield is preferably 0.1 or more.

The phosphorescent quantum yield may be determined by the method described in the Fourth Series of Experimental Chemistry, Vol. 7 Spectroscopy II, page 398 (1992, published by Maruzen) . The phosphorescent quantum yield may be determined with any solvent, and phosphorescent compounds having a phosphorescent quantum yield of 0.01 or more determined with any solvent may be used in the present invention.

Any known phosphorescent compounds used in the luminous layers of common organic EL elements may be appropriately used in the present invention. Preferred are complexes containing metal atoms belonging to groups 8 to 10 in the periodic table, more preferred are iridium, osmium, and platinum complexes (collectively referred to as platinum-based complexes) or rare earth complexes, and most preferred are iridium complexes.

In the present invention, one luminous layer may contain two or more phosphorescent compounds. The proportion of these phosphorescent compounds may vary along the thickness of the luminous layer.

Examples of the phosphorescent compounds usable in the present invention are listed in the following documents.

Nature 395,151(1998), Appl. Phys. Lett. 78, 1622(2001), Adv. Mater. 19, 739(2007), Chem. Mater. 17, 3532(2005), Adv. Mater. 17, 1059(2005), WO 2009/100991, WO 2008/101842, WO 2003/040257, and United States Patent Application Nos. 2006/835469, 2006/0202194, 2007/0087321, and 2005/0244673.

Further examples include Inorg. Chem. 40, 1704(2001), Chem. Mater. 16, 2480(2004), Adv. Mater. 16, 2003(2004), Angew. Chem. Int. Ed. 2006, 45, 7800, Appl. Phys. Lett. 86, 153505(2005), Chem. Lett. 34, 592(2005), Chem. Commun. 2906(2005), Inorg. Chem. 42, 1248(2003), WO 2009/050290, WO 2009/000673, United States Patent No. 7332232, United States Patent Application No. 2009/0039776, United States Patent No. 6687266, United States Patent Application Nos. 2006/0008670 and 2008/0015355, United States Patent No. 7396598, United States Patent Application No. 2003/0138657, and United States Patent No. 7090928.

Further examples include Angew. Chem. Int. Ed. 47,1(2008), Chem. Mater. 18, 5119(2006), Inorg. Chem. 46, 4308(2007), Organometallics 23, 3745(2004), Appl. Phys. Lett. 74, 1361(1999), WO 2006/056418, WO 2005/123873, WO 2005/123873, WO 2006/082742, United States Patent Application No. 2005/0260441, United States Patent No. 7534505, United States Patent Application No. 2007/0190359, United States Patent No. 7338722, United States Patent No. 7279704, and United States Patent Application No. 2006/103874.

Further examples include WO 2005/076380, WO 2008/140115, WO 011/134013, WO 2010/086089, WO 2012/020327, WO 2011/051404, WO 2011/073149, and Japanese Unexamined Patent Application Publication Nos. 2009-114086, 2003-81988, and 2002-363552.

Preferred phosphorescent compounds in the present invention are organometallic complexes containing iridium (Ir) as a central atom. More preferred are complexes having at least one coordinate bond selected from a metal-carbon bond, a metal-nitrogen bond, a metal-oxygen bond, and a metal-sulfur bond.

Such phosphorescent compounds or phosphorescent metal complexes may be prepared by the processes described, for example, in the following documents and references cited in these documents: Organic Letter, vol. 3, No.16, pp. 2579-2581 (2001), Inorganic Chemistry, vol. 30, No. 8, pp. 1685-1687 (1991), J. Am. Chem. Soc., vol. 123, p. 4304 (2001), Inorganic Chemistry, vol. 40, No. 7, pp. 1704-1711 (2001), Inorganic Chemistry, vol. 41, No. 12, pp. 3055-3066 (2002), New Journal of Chemistry., vol. 26, P. 1171 (2002), and European Journal of Organic Chemistry, vol. 4, pp. 695-709 (2004).

### <Fluorescent compound>

Examples of the fluorescent compound include coumarin dyes, pyran dyes, cyanine dyes, croconium dyes, squarylium dyes, oxobenzanthracene dyes, fluorescein dyes, rhodamine dyes, pyrylium dyes, perylene dyes, stilbene dyes, polythiophene dyes, and rare earth complex phosphors.

### (Organic functional layer group other than luminous layer)

The charge injection layer, the hole transport layer, the electron transport layer, and a barrier layer of the organic functional layer unit other than the luminous layer will now be described in sequence.

### (Charge injection layer)

The charge injection layer is provided between the electrode and the luminous layer to decrease the driving voltage and to increase the luminance. The detail of the charge injection layer is described in "Yuuki EL Debaisu to sono Kogyoka Saizensen (Front Line in Industrialization of Organic EL element)", Part II, Chapter 2, pp. 123-166, "Denkyoku Zairyo (Electrode materials)" (November 30, 1998 by N. T. S. Company) . The charge injection layers are classified into hole injection layers and electron injection layers.

With the charge injection layer, the hole injection layer is usually disposed between the anode and the luminous layer or hole transport layer, while the electron injection layer is usually disposed between the cathode and the luminous layer or electron transport layer. The present invention is characterized in that the charge injection layer is disposed adjacent to the transparent electrode. In the case where the charge injection layer is used as an intermediate electrode, at least one of the electron injection layer and the adjacent hole injection layer satisfies the requirement of the present invention.

The hole injection layer is provided adjacent to the transparent anode to decrease the driving voltage and to increase the luminance. The detail of this layer is described in "Yuuki EL Debaisu to sono Kogyoka Saizensen (Front Line in Industrialization of Organic EL element)", Part II, Chapter 2, pp. 123-166, "Denkyoku Zairyo (Electrode materials)" (November 30, 1998 by N. T. S. Company).

The hole injection layer is described in detail, for example, in Japanese Unexamined Patent Application Publication Nos. Hei 9-45479, Hei 9-260062, and Hei 8-288069. Examples of materials for the hole injection layer include porphyrin derivatives, phthalocyanine derivatives, oxazole derivatives, oxadiazole derivatives, triazole derivatives, imidazole derivatives, pyrazoline derivatives, pyrazolone derivatives, phenylenediamine derivatives, hydrazone derivatives, stilbene derivatives, polyarylalkane derivatives, triarylamine derivatives, carbazole derivatives, indrocarbazole derivatives, isoindole derivatives, acene derivatives e.g., anthracene and naphthalene, fluorene derivatives, fluorenone derivatives, polyvinylcarbazole, polymers and oligomers having arylamine main or side chains, polysilanes, and conductive polymers and oligomers, e.g., poly(ethylene dioxythiophene) (PEDOT), poly(styrene sulfonate) (PSS), aniline copolymers, polyaniline, and polythiophene.

Examples of the triarylamine derivatives include benzidine types such as
(4,4'-bis(N-(1-naphthyl)-N-phenylamino)biphenyl) (α-NPD), star-burst types, such as
MTDATA(4,4',4"-tris(N-(3-methylphenyl)-N-phenylamino)triphe nylamine), and compounds having fluorene and anthracene in the triarylamine coupling cores.

Alternatively, the hole transport material may be hexaazatriphenylene derivatives described in Japanese translation of PCT application 2003-519432 and Japanese Unexamined Patent Application Publication No. 2006-135145.

The electron injection layer is provided between the cathode and the luminous layer to decrease the driving voltage and to increase the luminance. The detail of the electron injection layer is described in "Yuuki EL Debaisu to sono Kogyoka Saizensen (Front Line in Industrialization of Organic EL element)". Part II, Chapter 2, pp. 123-166, "Denkyoku Zairyo (Electrode materials)" (November 30, 1998 by N. T. S. Company).

The electron injection layer is described in detail, for example, in Japanese Unexamined Patent Application Publication Nos. Hei 6-325871, Hei 9-17574, and Hei 10-74586. Examples of preferred materials for electron injection layer include metals, such as strontium and aluminum; alkali metal compounds, such as lithium fluoride, sodium fluoride, and potassium fluoride; alkali metal halides, such as magnesium fluoride and calcium fluoride; alkaline earth metal compounds, such as magnesium fluoride; metal oxides, such as molybdenum oxide and aluminum oxide; and metal complexes, such as lithium-8-hydroxyquinolate (Liq). In combination with a transparent cathode in the present invention, organic compounds such as metal complexes are particularly preferred. Preferably, the electron injection layer should have a significantly small thickness within the range of 1 nm to 10 µm, although it depends on the materials constituting the layer.

### (Hole transport layer)

The hole transport layer is composed of a hole transport material that will transport holes. The hole injection layer and electron blocking layer also function as a hole transport layer in a broad sense. The device may include a single hole transport layer or two or more hole transport layers.

The hole transport layer may be composed of any organic or inorganic compound which will inject or transport holes or will block electrons. Examples of such materials include triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, aniline copolymers, conductive polymers and oligomers, and thiophene oligomers.

The hole transport material may be porphyrin compounds, tertiary arylamine compounds, and styrylamine compounds, besides the compounds described above. Preferred are tertiary arylamine compounds.

Typical examples of the tertiary arylamine compound and styrylamine compounds include
N,N,N',N'-tetraphenyl-4,4'-diaminophenyl,
N,N'-diphenyl-N,N'-bis(3-methylphenyl)-(1,1'-biphenyl)-4,4' -diamine (TPD), 2,2-bis(4-di-p-tolylaminophenyl)propane, 1,1-bis(4-di-p-tolylaminophenyl)cyclohexane, N,N,N',N'-tetra-p-tolyl-4,4'-diaminobiphenyl, 1,1-bis(4-di-p-tolylaminophenyl)-4-phenylcyclohexane, bis(4-dimethylamino-2-methylphenyl)phenylmethane, bis(4-di-p-tolylaminopnenyl)phenylmethane, N,N'-diphenyl-N,N'-di(4-methoxyphenyl)-4,4'-diaminobiphenyl, N,N,N',N'-tetraphenyl-4,4'-diaminodiphenyl ether, 4,4'-bis(diphenylamino)quodriphenyl,
N,N,N-tri(p-tolyl)amine, 4-(di-p-tolylamino)-4'-(4-(di-p-tolylamino)styryl)stilbene, 4-N,N-diphenylamino-(2-diphenylvinyl)benzene, 3-methoxy-4'-N,N-diphenylaminostyrylbenzene, and N-phenylcarbazole.

A thin film of the hole transport layer may be formed with the hole transport material by any known process, for example, vacuum evaporation, spin coating, casting, printing such as ink jetting, or Langmuir Blodgett (LB) deposition. The hole transport layer may have any thickness, usually a thickness of about 5 nm to 5 µm, preferably 5 to 200 nm. The hole transport layer may have a single layer configuration composed of one or more of the materials described above.

The hole transport layer may be doped with any dopant to enhance p characteristics. Such techniques are described, for example, in Japanese Unexamined Patent Application Publication Nos. Hei 4-297076, 2000-196140, and 2001-102175, and J. Appl. Phys., 95, 5773(2004).

A hole transport layer with enhanced p characteristics advantageously contributes to production of devices with low power consumption.

### (Electron transport layer)

The electron transport layer is composed of a material that will transport electrons. An electron injection layer and a hole blocking layer correspond to electron transport layers in broad sense. The electron transport layer may have a monolayer or multilayer configuration.

In an electron transport layer having a monolayer or multilayer configuration, the electron transport material (also functioning as hole blocking material) constituting a layer adjacent to the luminous layer will transport electrons injected from the cathode to the luminous layer. Any known material may be used. Examples of such materials include nitro-substituted fluorene derivatives, diphenylquinone derivatives, thiopyrane dioxide derivatives, carbodiimides, fluorenylidene methane derivatives, anthraquinodimethane, anthrone derivatives, and oxadiazole derivatives. In addition, thiadiazole derivatives in which the oxygen atom in the oxadiazole ring is replaced with a sulfur atom in the oxadiazole derivatives, and quinoxaline derivatives having quinoxaline rings being electron attractive groups may also be used as materials for the electron transport layer. Polymer materials containing these materials as polymer chains or main chains may also be used.

Furthermore, materials for the electron transport layer may be metal complexes of 8-quinolinol derivatives, such as tris(8-quinolinol)aluminum (Alq₃), tris(5,7-dichloro-8-quinolinol)aluminum, tris(5,7-dibromo-8-quinolinol)aluminum, tris(2-methyl-8-quinolinol)aluminum, tris(5-methl-8-quinolinol)aluminum, and bis (8-quinolinol) zinc (Znq) ; and metal complexes of which the central metals are replaced with In, Mg, Cu, Ca, Sn, Ga, or Pb.

A thin film of the electron transport layer may be formed with the electron transport material by any known process, for example, vacuum evaporation, spin coating, casting, printing such as ink jetting, or Langmuir Blodgett (LB) deposition. The electron transport layer may have any thickness, usually a thickness of about 5 nm to 5 µm, preferably 5 to 200nm. The electron transport layer may have a single layer configuration composed of one or more of the materials described above.

### (Blocking layer)

The blocking layers are classified into hole blocking layers and electron blocking layers. These layers may be provided as needed in addition to the individual layers in the organic functional layer unit 3 described above. Examples of the blocking layer are disclosed in Japanese Unexamined Patent Application Publication Nos. Hei 11-204258 and Hei 11-204359, and hole blocking layers described in "Yuuki EL Debaisu to sono Kogyoka Saizensen (Front Line in Industrialization of Organic EL element)", p. 237, (November 30, 1998 by N. T. S. Company).

The hole blocking layer also functions as an electron transport layer in a broad sense. The hole blocking layer is composed of a hole blocking material that will transport electrons but barely transport holes. Since the hole blocking layer transports electrons while blocking holes, the layer will enhance the opportunity of recombination of electrons and holes. The configuration of the electron transport layer may be used as a hole blocking layer. Preferably, the hole blocking layer is disposed adjacent to the luminous layer.

The electron blocking layer also functions as a hole transport layer in a broad sense. The electron blocking layer is composed of an electron blocking material that will transport holes but barely transport electrons. Since the electron blocking layer transports holes while blocking electrons, the layer will enhance the opportunity of recombination of electrons and holes. The configuration of the hole transport layer may be used as an electron blocking layer. The hole blocking layer in the present invention has a thickness in the range of preferably 3 to 100 nm, more preferably 5 to 30 nm.

### (Cathode)

The cathode feeds holes to the organic functional layer group and the luminous layer, and it is composed of a metal, alloy, organic or inorganic conductive compound, or a mixture thereof. Specific examples include gold, aluminum, silver, magnesium, lithium, magnesium/copper mixtures, magnesium/silver mixtures, magnesium/aluminum mixtures, magnesium/indium mixtures, indium, lithium/aluminum mixture, rare earth metals, and oxide semiconductors, such as ITO, ZnO, TiO₂, and SnO₂.

A thin film of the cathode may be prepared with these conductive materials by evaporation or sputtering. The cathode as a second electrode has a sheet resistance of preferably several hundred Ω/sq. or less, and a thickness of in the range of generally 5 nm to 5 µm, preferably 5 to 200 nm.

For an organic EL element that also emits light from the cathode or that is of a double sided emission type, a cathode having high light transmissivity is selected.

### (Sealing member)

The organic EL element may be sealed, for example, by adhesion of a sealing member with the cathode and transparent substrate with an adhesive.

The sealing member is disposed so as to cover the display region of the organic EL element, and may have a concave or flat shape. The sealing member may have any transparency and electrical insulation.

Examples of the sealing member include glass plates, polymer plates, films, metal plates, and films. Examples of glass of the glass plate include soda lime glass, barium and strontium containing glass, lead glass, aluminosilicate glass, borosilicate glass, barium borosilicate glass, and quartz. Examples of materials for the polymer plate include polycarbonates, acrylic resins, poly(ethylene terephthalate), poly(ether sulfides), and polysulfones. Examples of metals of the metal plate include stainless steel, iron, copper, aluminum, magnesium, nickel, zinc, chromium, titanium, molybdenum, silicon, germanium, tantalum, and alloys thereof.

Preferred sealing members are composed of polymer or metal films that will reduce the thickness of the organic EL element. Preferably, the polymer film should have a moisture permeability of 1 x 10⁻³g/m²·24h or less at a temperature of 25 ± 0.5 °C and a relative humidity of 90 ± 2 %RH in accordance with JIS K 7129-1992 and more preferably an oxygen permeability of 1 x 10⁻³ml/m²·24h·atm (where 1 atm is 1. 01325 x 10⁵Pa) or less in accordance with JIS K 7126-1987 and a moisture permeability of 1 x 10⁻³g/m²·24h or less at a temperature of 25 ± 0.5 °C and a relative humidity of 90 ± 2 %RH.

The gap between the sealing member and the display region (emission region) of the organic EL element should preferably be filled with inert gas, for example, nitrogen, argon, or fluorohydrocarbon, or inert liquid, for example, silicone oil. Alternatively, the gap between the sealing member and the display region of the organic EL element may be vacuum or may be filled with a hygroscopic compound.

### (Production method of organic EL element)

The organic EL element is produced by depositing an anode, an organic functional layer group 1, a luminous layer, another organic functional layer group 2, and a cathode on a transparent substrate.

A transparent substrate is prepared. A thin film of a desired electrode material, for example, an anode material is deposited onto the transparent substrate into a thickness of 1 µm or less, preferably in the range of 10 to 200 nm by evaporation or sputtering, for example, to form an anode. A connection terminal to be connected to an external power source is formed.

A hole injection layer and a hole transport layer of an organic functional layer group 1, a luminous layer, and an electron transport layer of another organic functional layer group 2 are then deposited in sequence.

These layers may be formed by spin coating, casting, ink jetting, evaporation, or printing. Particularly preferred are vacuum evaporation and spin coating, which will form uniform layers without pinholes. Individual layers may be formed by different processes. In the case of evaporation, each layer is preferably formed under the following evaporation conditions: a boat heating temperature in the range of 50 to 450 °C, a degree of vacuum of 1 x 10⁻⁶ to 1 x 10⁻² Pa, an evaporation rate of 0.01 to 50 nm/sec, and a substrate temperature of -50 to 300 °C, and a thickness of 0.1 to 5 µm, although these conditions vary depending on the type of the compound used.

A cathode is formed by patterning on the organic functional layer group 2 by an appropriate process, such as evaporation or sputtering such that the cathode is insulated from the anode by the organic functional layer group and extends from above the organic functional layer group to the periphery of the transparent substrate.

After the formation of the cathode, the transparent substrate, anode, organic functional layer groups, luminous layer, and cathode are sealed with a sealing member. In detail, the terminals of the anode and cathode (leads of these electrodes) are exposed, and the sealing member covers at least the organic functional layer group on the transparent substrate.

In the production of the organic EL panel, for example, each electrode of the organic EL device is electrically connected to a light-emitting device driving circuit unit (12) or a touch sensing circuit unit (14). Any conductive material may be used for electrical connection (extending lead), and preferred are anisotropic conductive films (ACFs), conductive paste, or metal paste.

For example, the anisotropic conductive film (ACF) may be a layer containing fine conductive particles dispersed in thermally curable resin. In the present invention, the layer may contain any fine conductive particles having electrical anisotropy, which may be appropriately selected for any purpose. Examples of the conductive particles usable in anisotropic conductive materials include metal particles and metallized resin particles. Commercially available ACFs are, for example, low-temperature-curable ACFs applicable to a resin film, such as MF-331 (available from Hitachi Chemical Co. Ltd.).

Examples of metal for metal particles include nickel, cobalt, silver, copper, gold, and palladium. Examples of metallized resin particles include resin cores covered with nickel, copper, gold, or palladium. Examples of the metal paste include commercially available metal nanoparticle pastes.

### <<Field of application of organic EL module>>

The organic EL module of the present invention contributes to reduction in sizes and thickness of the device, and may be produced through simplified production steps. The organic EL module is favorably used for various types of smart devices, such as smart phones and tablets as described in FIG. 1, and illumination devices.

### (Illumination device)

The organic EL module of the present invention may also be applied to illumination devices. Examples of illumination devices provided with the organic electroluminescent module of the present invention include domestic lighting, vehicle lighting, backlights of liquid crystal displays, and displays. Further examples include backlight of watches; billboard advertisements; traffic signals; light sources of optical memory media, electrophotographic copying machines, optical communication devices, and photosensors; and domestic electric devices provided with displays.

### INDUSTRIAL APPLICABILITY

The organic EL module of the present invention has an organic electroluminescent panel including a plurality of organic electroluminescent elements laid out in series provided with an electrode used for both a light-emission function and a touch-sensing function, and a specific control circuit. It enables to prevent error touch sensing in touch function between a plurality of organic electroluminescent elements, with achieving a small format and a small thickness, and simplified process, and to provide a smart device, such as smart phones and tablets, and an illumination apparatus provided with this organic EL module.

### DESCRIPTION OF SYMBOLS

1: MD (Organic EL module)
2: Organic EL panel
3: Transparent substrate
4, 4A, 4B and 4C: Anode
5: Organic functional layer unit
6, 6A, 6B and 6C: Cathode
7: Sealing adhesive
8: Sealing member
9: Touch sensing unit
10: Traditional touch sensing electrode
11: Cover glass
12: Light-emitting device driving circuit unit
13: Separable touch sensing circuit unit
14: Touch sensing circuit unit
15: Finger
16: Ground (earth)
21A, 21B, and 21C: Parasitic capacitance (Cel) of organic EL element
22A, 22B, and 22C: Organic EL element
23: Light emitting device driving circuit section
24, 24A, 24B, and 24C: Touch sensing circuit section
25A, 25B, and 25C: Anode lead
26A, 26B, and 26C: Cathode lead
27, 27A and 27B: Ground
Route 2: Emission control information route
Route 1, Route 3A, Route 3B, Route 3C, Route 4, Route 5, Route
6, and Route 7: Touch sensing information route
30: Capacitor (Cs)
31: DC-DC converter circuit section
32: Switch device control circuit section of DC-DC converter
33: Electric current feedback circuit section
34: Capacitor
100: Smart device
111A, 111B, and 111C: Display pattern
120: Liquid crystal display
1FT: One frame term
Cf: Capacitance at finger touch
LT: Emission term
R₁: Sensing resistance
ST: Sensing term
SW1: First switch
SW2: Second switch
SW3: Third switch
SW4: Fourth switch
SW5: Fifth switch
SW6: Sixth switch
SW7: Seventh switch
t1: Waiting term
V: Applied electric source section
τ: OLED charge/discharge time constant

## Claims

1. An organic electroluminescent module having a touch sensing function, the organic electroluminescent module comprising:
a touch sensing circuit unit containing a capacitive touch sensing circuit section; and
a light-emitting device driving circuit unit containing a light-emitting device driving circuit section for driving an organic electroluminescent panel,
wherein the organic electroluminescent panel has a configuration composed of two or more organic electroluminescent elements each laid out in series,
the organic electroluminescent element comprises paired opposite plate electrodes therein,
one of the paired electrodes is a touch sensing electrode, the touch sensing electrode being connected to the touch sensing circuit unit, and
the two or more organic electroluminescent elements laid out in series respectively have an independent sensing device to carry out touch sensing independently.

2. The organic electroluminescent module described in claim 1, wherein the independent sensing device is a device having a switch at a connecting portion of the two or more organic electroluminescent elements laid out in series, and capable of independently sensing a finger-touch to each of the organic electroluminescent elements.

3. The organic electroluminescent module described in claim 2, wherein the switch is turned on during an emission term of the organic electroluminescent element, and the switch is turned off during a touch sensing term.

4. The organic electroluminescent module described in claims 2 or 3, wherein the switch is located in the light-emitting device driving circuit unit.

5. The organic electroluminescent module described in claim 1, wherein the independent sensing device is a device having a resistor at a connecting portion of the two or more organic electroluminescent elements laid out in series, and capable of independently sensing a finger-touch to each of the organic electroluminescent elements by a time constant derived from the resistor and the organic electroluminescent element capacitance.

6. The organic electroluminescent module described in any one of claims 1 to 5, wherein the touch sensing circuit unit and the light-emitting device driving circuit unit are connected to a common ground.

7. The organic electroluminescent module described in any one of claims 1 to 5, wherein the touch sensing circuit unit and the light-emitting device driving circuit unit each are connected to an independent ground.

8. The organic electroluminescent module described in any one of claims 1 to 7,
wherein the emission term of the organic electroluminescent element controlled by the light-emitting device driving circuit section is separated from the touch sensing term controlled by the touch sensing circuit section, and
at least one of the paired electrodes is in a floating potential during the touch sensing term to prevent detection of the capacitance of the organic electroluminescent element.

9. The organic electroluminescent module described in any one of claims 1 to 7,
wherein the emission term of the organic electroluminescent element controlled by the light-emitting device driving circuit section is separated from the touch sensing term controlled by the touch sensing circuit section, and
both of the paired electrodes are in a floating potential during the touch sensing term to prevent detection of the capacitance of the organic electroluminescent panel.

10. The organic electroluminescent module described in any one of claims 1 to 7,
wherein the emission term of the organic electroluminescent panel controlled by the light-emitting device driving circuit section is separated from the touch sensing term controlled by the touch sensing circuit section, and
at least one of the paired electrodes is in a floating potential during the touch sensing term and the paired electrodes are short-circuited to prevent detection of the capacitance of the organic electroluminescent panel.

11. The organic electroluminescent module described in any one of claims 1 to 7,
wherein the emission term of the organic electroluminescent panel controlled by the light-emitting device driving circuit section is separated from the touch sensing term controlled by the touch sensing circuit section, and
both of the paired electrodes are in a floating potential during the touch sensing term and the paired electrodes are short-circuited to prevent detection of the capacitance of the organic electroluminescent panel.

12. The organic electroluminescent module described in any one of claims 1 to 11,
wherein the organic electroluminescent element controlled by the light-emitting device driving circuit section is driven to continuously emit light, while the touch sensing term periodically occurs under the control of the touch sensing circuit section.

13. The organic electroluminescent module described in any one of claims 1 to 11, wherein the emission term includes a reverse-voltage applying term at the end of the emission term.

14. A smart device comprising the organic electroluminescent module described in any one of claims 1 to 13.

15. An illumination apparatus comprising the organic electroluminescent module described in any one of claims 1 to 13.
